# EUROPEAN PATENT SPECIFICATION

(11) **EP 2 570 853 B1**
(45) Date of publication and mention of the grant of the patent: **20.08.2014**
(21) Application number: 12182574.9
(22) Date of filing: 31.08.2012
(51) Int. Cl.: G03F 7/09

(54) **Oxygen-blocking film and lithographic printing plate precursor comprising said film**
Sauerstoffblockfolie und lithografischer Druckplattenvorläufer mit dieser Sauerstoffblockfolie
Film barrière anti-oxygène et précurseur de plaque d'impression lithographique le comprenant

(30) Priority: 15.09.2011 JP 2011202000
(43) Date of publication of application: 20.03.2013
(73) Proprietor: Fujifilm Corporation, Minato-ku Tokyo (JP)
(72) Inventor: Oohashi, Hidekazu, Shizuoka (JP)
(74) Representative: HOFFMANN EITLE

(56) References cited:
- EP-A1- 1 901 124

## Description

### FIELD OF THE INVENTION

The present invention relates to a coating composition containing a polymer having a specific repeating unit and an oxygen-blocking film, an image-forming material and a lithographic printing plate precursor using the coating composition.

### BACKGROUND OF THE INVENTION

Polyvinyl alcohol (PVA) has high oxygen-blocking property and is used as a protective layer for preventing oxygen inhibition of an image-forming material having a photosensitive layer of radical polymerization type. In particular, in the field of a lithographic printing plate precursor, a protective layer containing PVA which is provided with functions of an oxygen-blocking property for preventing oxygen inhibition of a radical polymerizable photosensitive layer and a protective property for preventing the occurrence of scratches during conveying or handling is used.

As for a lithographic printing plate precursor capable of undergoing on-press development, for example, a lithographic printing plate precursor capable of undergoing on-press development comprising a support having provided thereon an image-recording layer (photosensitive layer) containing a polymerizable compound and a graft polymer having a polyethylene oxide chain in its side chain or a block polymer having a polyethylene oxide block and further having provided thereon a protective layer containing polyvinyl alcohol is described in US 2003/0064318 A1. Further, a lithographic printing plate precursor comprising a hydrophilic support having thereon an image-recording layer containing microcapsules having a polymerizable compound encapsulated therein and a protective layer containing a hydrophilic resin, for example, polyvinyl alcohol and an inorganic stratiform compound is described in JP-A-2005-119273 (the term "JP-A" as used herein means an "unexamined published Japanese patent application").

However, the presence of such a protective layer may cause sometimes decrease in on-press development speed. When the coating amount of the protective layer is decreased in order to improve the on-press development property, the oxygen-blocking property deteriorates so that decrease in sensitivity and decrease in printing durability of a lithographic printing plate obtained from the lithographic printing plate precursor may arise sometimes. Also, the hydrophilic resin may cause deposit on a printing machine at the time of on-press development in some cases depending on the kind of hydrophilic resin.

On the other hand, as for a lithographic printing plate precursor capable of undergoing development with a developer, for example, a protective layer containing polyvinyl alcohol and a cation-modified polyvinyl alcohol is described in JP-A-2007-298645. A protective layer containing a modified polyvinyl alcohol having an acid group or a salt thereof in its molecule is described in JP-A-2006-53316 and JP-A-2006-259137. Polyvinyl alcohol is ordinarily used in the protective layer, however, when polyvinyl alcohol having a high saponification degree is used in order to improve the oxygen-blocking property, the occurrence of deposit (development scum) in the developer becomes marked. The deposit in the developer can be inhibited by using polyvinyl alcohol modified with an acid group. However, such modification causes decrease in the oxygen-blocking property so that decrease in sensitivity and printing durability may arise sometimes.

Also, polyvinyl alcohol (PVA) is used as a packaging film provided with a gas barrier property for preventing transmission of oxygen or the like or a material provided with a gas barrier property which is prepared by coating polyvinyl alcohol on a polymer film, for example, a polyolefin film, a nylon film or a polyethylene terephthalate film.

On the other hand, it is described that a polymer containing poly-α-hydroxyacrylic acid can be used as a stabilizer in case of bleaching fiber or paper with hydrogen peroxide in JP-T-2001-510489 (the term "JP-T" as used herein means a published Japanese translation of a PCT patent application) and JP-B-62-23111 (the term "JP-B" as used herein means an "examined Japanese patent publication"). However, it is not known that the polymer containing poly-α-hydroxyacrylic acid is utilized as a coating material, a protective layer for preventing oxygen inhibition of an image-forming material having a photosensitive layer of radical polymerization type or a gas barrier material.

EP-A-1 901 124 disclose an image recording material comprising a shielding oxygen layer as protective layer, that contains an organic polymer.

### SUMMARY OF THE INVENTION

An object of the present invention is to provide a novel coating composition capable of providing coating having a high oxygen-blocking property, and an image-forming material or lithographic printing plate precursor excellent in development property and strength of an image obtained by development and an excellent oxygen-blocking film using the coating composition.

As a result of the intensive investigations for achieving the object described above, the inventors have found that the problem can be solved according to the following inventions.
(1) A coating composition comprising a polymer having a structural unit represented by formula (1) shown below. 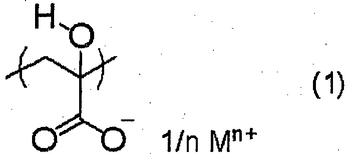
   In formula (1), Mⁿ⁺ represents a cation having an n-valent positive charge, and n represents an integer from 1 to 4.
(2) The coating composition as described in (1) above, wherein the cation having an n-valent positive charge is at least one cation selected from a proton, a metal cation, an ammonium cation, a phosphonium cation, an iodonium cation, a sulfonium cation, a diazonium cation and an azinium cation.
(3) The coating composition as described in (2) above, wherein the cation having an n-valent positive charge is at least one cation selected from a proton, a metal cation, an ammonium cation and a phosphonium cation.
(4) The coating composition as described in any one of (1) to (3) above, which further contains an inorganic stratiform compound.
(5) The coating composition as described in any one of (1) to (4) above, which further contains a crosslinking agent.
(6) An image-forming material comprising, in the following order: a support; a photosensitive layer containing at least a radical polymerizable compound and a photo initiator; and a protective layer containing the coating composition as described in any one of (1) to (4) above. The phrase "in the following order" does not exclude the possibility that any other layer(s) may be provided between the support and the photosensitive layer or between the photosensitive layer and the protective layer.
(7) A lithographic printing plate precursor comprising, in the following order: a support; a photosensitive layer containing a radical polymerizable compound and a photo initiator; and a protective layer containing the coating composition as described in any one of (1) to (4) above.
(8) An oxygen-blocking film having a layer comprising the coating composition as described in any one of (1) to (5) above.

According to the present invention, a novel coating composition capable of providing coating having a high oxygen-blocking property, and an image-forming material or lithographic printing plate precursor excellent in development property and strength of an image obtained by development and an excellent oxygen-blocking film using the coating composition can be obtained.

### BRIEF DESCRIPTION OF THE DRAWINGS

Fig. 1 is a view explaining a structure of automatic development processor A.
Fig. 2 is a view explaining a structure of automatic development processor B.

### [Description of reference numerals and signs]

61: Rotating brush roller
62: Backing roller
63: Transport roller
64: Transport guide plate
65: Spray pipe
66: Pipe line
67: Filter
68: Plate supply table
69: Plate discharge table
70: Developer tank
71: Circulating pump
72: Lithographic printing plate precursor
11: Transporting path
100: Automatic development processor body
200: Pre-heating unit
300: Developing unit
400: Drying unit
202: Machine casing
204: Heating unit
208: Heating chamber
210: Skewerroller
212: Transporting inlet
214: Heater
216: Circulation fan
218: Transporting outlet
A: Insertion unit
304: Insertion roller pair
306: Processing tank
306a: Processing tank margin
308: Developing tank (filled with a developer)
310: Outer panel
312: Slit type insertion slot
316: Submerged roller pair
318: Carrying-out roller pair
322: Brush roller pair
324: Shielding cover
326: Brush roller pair
330: Spray pipe
(*which is constructed to supply a developer in the developing tank 308 sucked by a pump (not shown) and the developer is ejected from the spray pipe 330 in the developing tank 308)
334: Slit type path-through slot
336: Liquid temperature sensor
338: Liquid level meter
332: Partition board
342: Guide member
344: Guide roller
402: Support roller
404: Discharge slot
406: Transport roller pair
408: Transport roller pair
410,412: Duct
414: Slit hole
50: External tank (developer storage)
51: Overflow aperture
52: Upper limit liquid level meter
53: Lower limit liquid level meter
54: Filter unit
55: Developer supply pump
C1: First circulation pipeline
C2: Second circulation pipeline
71: Water tank for replenishment (water storage)
72: Water-replenishing pump
C3: Circulation pipeline for water replenishment

### DETAILED DESCRIPTION OF THE INVENTION

### [Coating composition]

The coating composition according to the invention is characterized by containing a polymer (hereinafter abbreviated as polymer A) having a structural unit represented by formula (1) shown below. By containing polymer A, the coating composition according to the invention can form coating having a high oxygen-blocking property. The coating is used as a protective layer having an oxygen-blocking property in an image-forming material or lithographic printing plate precursor described hereinafter and as an oxygen-blocking layer in an oxygen-blocking film.

### [Polymer A]

The polymer A for use in the invention is a polymer having a repeating unit represented by formula (1) shown below.

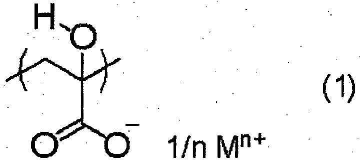

In formula (1), Mⁿ⁺ represents a cation having an n-valent positive charge, and n represents an integer from 1 to 4.

The cation having an n-valent positive charge represented by Mⁿ⁺ includes an existing cation having a positive charge, for example, a proton, a metal cation, an ammonium cation, a phosphonium cation, an iodonium cation, a sulfonium cation, a diazonium cation or an azinium cation. Of the cations, a proton, a metal cation, an ammonium cation or a phosphonium cation is preferred, a proton, a metal cation or an ammonium cation is more preferred, and a proton or a metal cation is particularly preferred.

n represents a valence of positive charge of the cation and is an integer from 1 to 4. A preferred value of n may varied depending on the intended use of the coating composition. In case of using as a protective layer for preventing oxygen inhibition of an image-forming material having a photosensitive layer of radical polymerization type, n is preferably 1 or 2, and particularly preferably 1. By selecting the valence as described above, good development property and sensitivity and good printing durability of a lithographic printing plate obtained by development of a lithographic printing plate precursor are obtained. In case of using for an oxygen-blocking film, n is preferably from 2 to 4, and particularly preferably 3 or 4. By selecting the valence as described above, good oxygen-blocking property and film strength are obtained.

Specific examples of the metal cation include Li⁺, Na⁺, K⁺, Mg²⁺, Ca²⁺, Cu⁺, Cu²⁺, Al³⁺, Fe²⁺, Fe³⁺, Co²⁺, Ni²⁺ or Zn²⁺. Also, a metal complex cation formed from the metal cation and a chelating agent can be used. Specific examples of the ammonium cation and phosphonium cation include cations represented by formula (i) shown below.

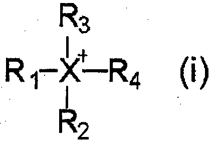

In formula (i), X represents N or P, and R₁ to R₄ each represents a hydrogen atom, an alkyl group or an aryl group.

Specific examples of the alkyl group represented by any one of R₁ to R₄ include a straight-chain alkyl group, for example, a methyl group, an ethyl group, a propyl group, a butyl group, a pentyl group, a hexyl group, a heptyl group, an octyl group, a nonyl group, a decyl group or an octadecyl group; a branched alkyl group, for example, an isopropyl group, an isobutyl group, a tert-butyl group, a sec-butyl group, an isopentyl group, a neopentyl group, a 2-ethylhexyl group or an isodecyl group; and a cyclic alkyl group, for example, a cyclopropyl, a cyclobutyl, a cyclopentyl group or a cyclohexyl group. The alkyl group may have a substituent, for example, an aryl group, for example, a phenyl group, a hydroxy group, a mercapto group, an alkoxy group, an alkylthio group, a halogen atom, a carboxyl group, an alkoxycarbonyl group, a nitro group, a cyano group, an amino group, an ammonium group or a phosphonium group.

Specific examples of the alkyl group having a substituent include a 2-hydroxyethyl group, a 2-hydroxypropyl group, a 3-hydroxypropyl group, a 2,3-dihydroxypropyl group, an ethylthioethyl group, a 2-mercaptoethyl group, a 2-methoxyethyl group, a 2-ethoxyethyl group, a 2-(2-methoxy)ethoxyethyl group, a benzyl group, a cyanoethyl group, an acetoxyethyl group, 2-chloroethyl group, a carboxymethyl group, a methoxycarbonylmethyl group, a 2-acetylaminoethyl group, a 2-vinyloxyethyl group, a tetrahydrofurfuryl group, a 2-dimethylaminoethyl group, a 2-trimethylammoniumethyl group, a 3-trimethylammoniumpropyl group, a 2-triphenylphosphoniumethyl group, a 3-triphenylphosphoniumpropyl group and a 9-triphenylphosphoniumnonyl group.

Also, appropriate two substituents for R₁ to R₄ may combine to form a ring. Specific examples of the group for forming a ring include -CH₂CH₂-, -CH₂CH₂CH₂-, -CH₂CH₂CH₂CH₂-, -CH₂CH₂CH₂CH₂CH₂-, -CH₂CH₂OCH₂CH₂-, -CH₂CH₂NNCH₂CH₂- and -CH₂CH₂NMeCH₂CH₂-, which are formed by combination of appropriate two substituents for R₁ to R₄.

In case of using as the protective layer for preventing oxygen inhibition of an image-forming material having a photosensitive layer of radical polymerization type, a number of carbon atoms in the alkyl group is preferably from 1 to 6, more preferably from 1 to 4, and particularly preferably 1 or 2. By selecting the number of carbon atoms described above, good development property, good sensitivity and good printing durability of a lithographic printing plate obtained from a lithographic printing plate precursor are obtained.

In case of using for the oxygen-blocking film, the number of carbon atoms in the alkyl group is not particularly restricted, but when it is desired to impart water resistance to the oxygen-blocking film, it is preferably from 6 to 24, more preferably from 8 to 22, and particularly preferably from 10 or 20.

Specific examples of the aryl group represented by any one of R₁ to R₄ include a phenyl group, a naphthyl group or an anthranyl group. The aryl group may have a substituent, for example, an aryl group, for example, a phenyl group, a hydroxy group, an alkoxy group, a halogen atom, a carboxyl group, an alkoxycarbonyl group, a nitro group, a cyano group, an amino group, an ammonium group, a phosphonium group or an alkyl group. Specific examples of the aryl group having a substituent include a tolyl group, a methoxyphenyl group, a chlorophenyl group and a hydroxyphenyl group.

In case of using for the oxygen-blocking film, the number of carbon atoms in the aryl group is not particularly restricted, but when it is desired to impart water resistance to the oxygen-blocking film, it is preferably from 6 to 24, more preferably from 8 to 22, and particularly preferably from 10 or 20.

In case of using as the protective layer for preventing oxygen inhibition of an image-forming material having a photosensitive layer of radical polymerization type, a number of carbon atoms in the aryl group is preferably from 6 to 12, and more preferably 6. By selecting the number of carbon atoms described above, good development property, good sensitivity and good printing durability of a lithographic printing plate obtained from a lithographic printing plate precursor are obtained.

Specific examples of the ammonium cation represented by formula (i) include NH⁴⁺, an ammonium cation obtained by protonation of an existing amine compound and an ammonium cation obtained by quaternization of an existing amine compound with an alkylating agent. Among them, ammonium cations represented the structural formulae shown below are more preferred.

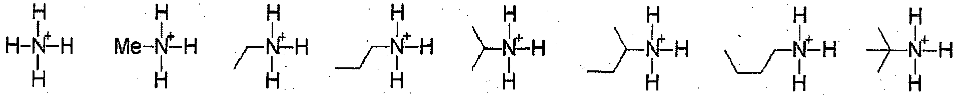

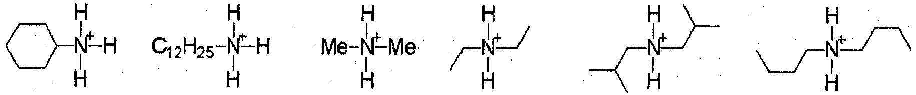

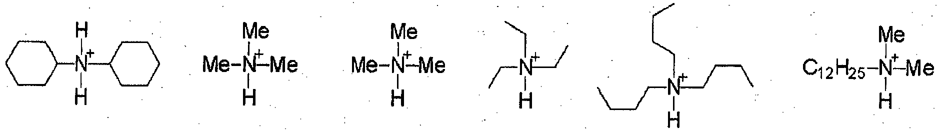

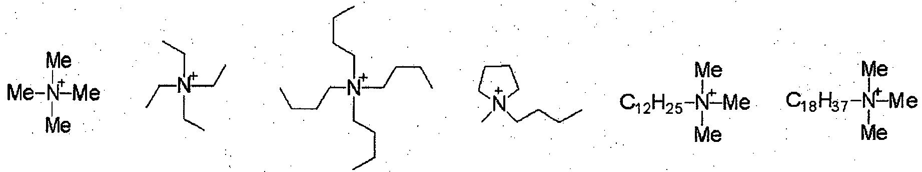

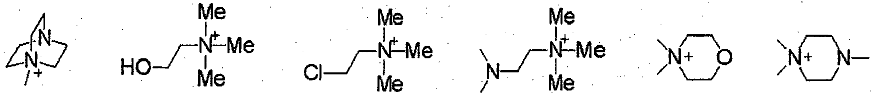

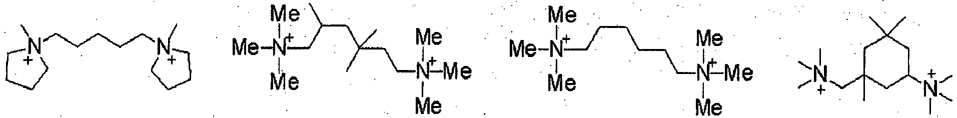

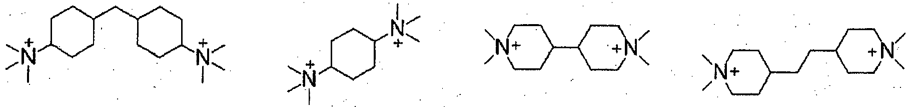

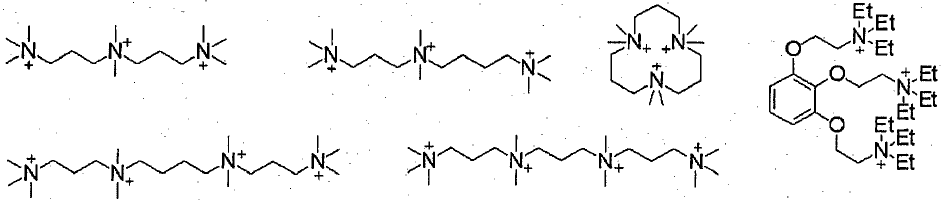

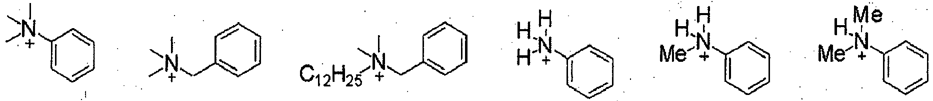

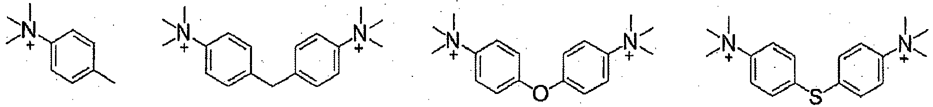

Specific examples of the phosphonium cation represented by formula (i) include an existing phosphonium cation and a phosphonium cation obtained by quaternization of an existing phosphine compound with an alkylating agent. Among them, phosphonium cations represented the structural formulae shown below are more preferred.

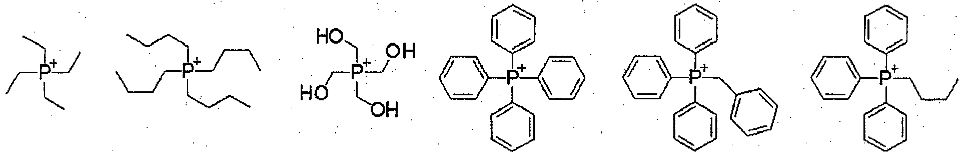

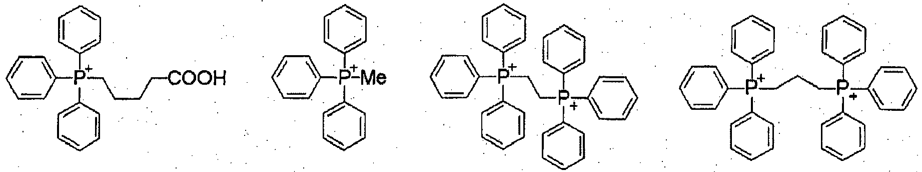

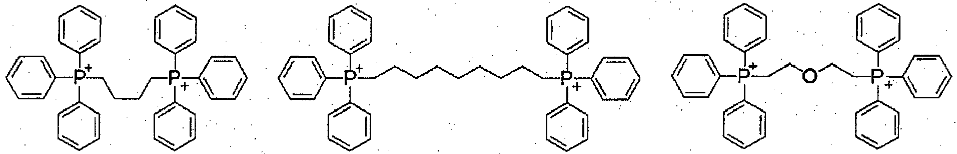

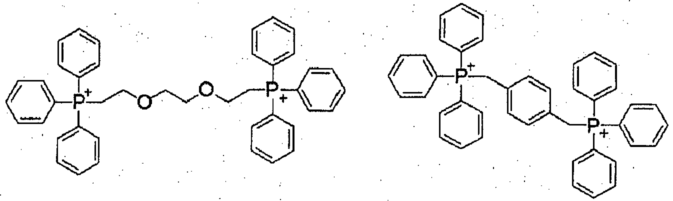

Specific examples of the iodonium cation include an existing iodonium salt, for example, diphenyl iodonium or di-tert-butylphenyl iodonium.

Specific examples of the sulfonium cation include an existing sulfonium salt, for example, triphenyl sulfonium or tri(chlorophenyl) sulfonium.

Specific examples of the diazonium cation include an existing diazonium salt, for example, phenyl diazonium.

Specific examples of the azinium cation include an existing azinium salt, for example, N-methoxyazinium.

The cations may be used in combination. Also, a cation having different cations in its molecule can be used.

As the polymer A for use in the invention, any polymer having the repeating unit represented by formula (i) described above can be preferably used. As a method of preparing the polymer A, the methods described in JP-T-2001-510489 and JP-B-62-23111, a method wherein α-chloroacrylic acid is used as a monomer and polymerized by ordinary radical polymerization and then the chloro group is converted to a hydroxy group with an aqueous alkali solution or an aqueous acid solution and a method wherein an α-acyloxyacrylate ester derived from a pyruvate is used as a monomer and polymerized by ordinary radical polymerization and then the ester group is hydrolyzed with an aqueous alkali solution or an aqueous acid solution are exemplified.

The mole fraction of the repeating unit represented by formula (1) contained in the polymer A according to the invention is preferably from 20 to 100% by mole, more preferably from 25 to 100% by mole, and particularly preferably from 30 to 100% by mole.

The polymer A for use in the invention may contain a repeating unit other than the repeating unit represented by formula (1) so far as the oxygen-blocking property and development property which are objects of the invention are not impaired. The repeating unit other than the repeating unit represented by formula (1) can be introduced by copolymerization of an existing monomer together with α-chloroacrylic acid or α-acyloxyacrylate ester.

Existing radical-polymerizable monomer can be preferably used in the preparation of polymer (A) according to the invention and can be used by appropriate selection depending on the intended use. Examples of the existing monomer include vinyl acetate, acrylic acid, methacrylic acid, an acrylate, a methacrylate, acrylonitrile, methacrylonitrile, an acrylamide, a methacrylamide, styrene, itaconic acid, an itaconate, an itaconamide, fumaric acid, a fumarate, a fumaramide, maleic acid, a maleate and a maleinamide. Specific examples of the ester include methyl ester, ethyl ester, butyl ester, isobutyl ester, tert-butyl ester, benzyl ester, hexyl ester, cyclohexyl ester, 2-ethylhexyl ester and dodecyl ester. Specific examples of the amide include amide, methylamide, isopropylamide, dimethylamide, morpholinoamide and 1-sulfo-2-methyl-2-propylamide.

Specific examples of the polymer A for use in the invention are set forth below, but the invention should not be construed as being limited thereto. A weight average molecular weight (Mw) of the polymer is indicated in parentheses.

Unless otherwise noted, a numerical value appended to a repeating unit (a numerical value appended to a repeating unit of a main chain) of the polymer indicates a mole percent of the repeating unit.

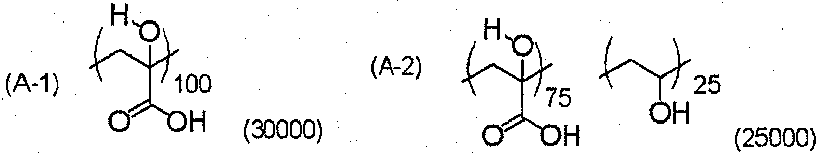

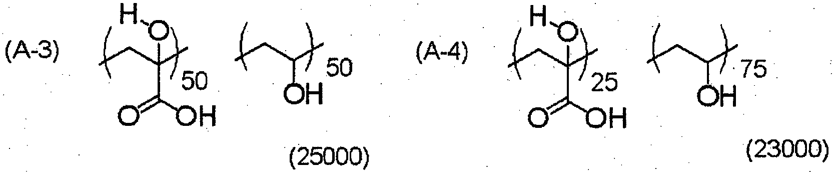

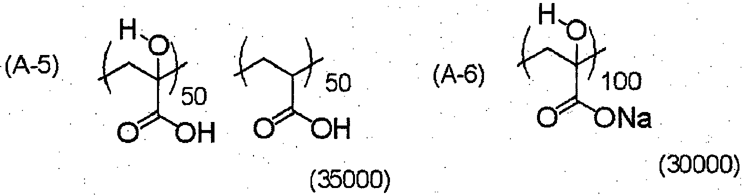

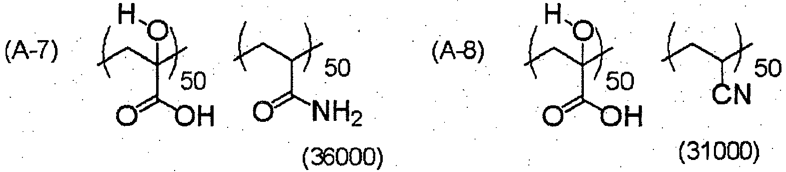

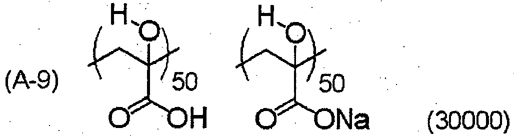

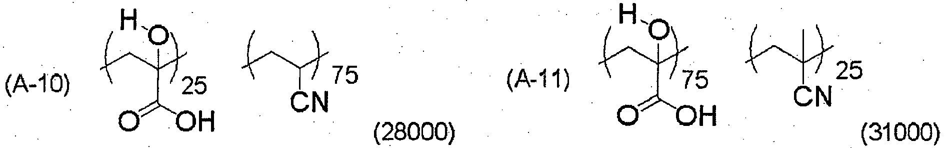

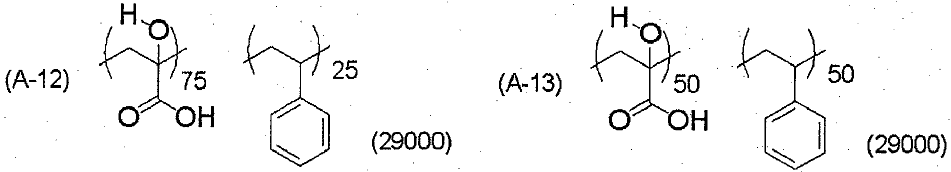

### <Preparation Example of Polymer A-6>

In a predetermined amount of xylene were dissolved 100 g of ethyl α-acetoxyacrylate and 2,2'-azobisisobutyronitrile (0.4% by mole based on the monomer) to prepare a solution (monomer concentration: 30% by weight). The solution was subjected to nitrogen bubbling for 10 minutes and then stirred at 60°C for 10 hours under nitrogen stream to progress a polymerization reaction. The reaction solution obtained was dissolved in 300 ml of dichloromethane and gradually added dropwise to 5 liters of methanol. A white polymer precipitated was collected by filtration and dried in a vacuum overnight to obtain a homopolymer of ethyl α-acetoxyacrylate. A weight average molecular weight (Mw) of the homopolymer obtained was 60,000.

The homopolymer was dissolved in tetrahydrofuran and brought into contact with sodium hydroxide at 40°C to undergo a saponification reaction, and the resulting resin was washed with methanol soxhlet for 24 hours. Thus, Polymer A-6 was obtained.

### <Preparation Example of Polymer A-1>

Polymer A-6 obtained as described above was treated using a cation exchange resin to convert Na⁺ to H⁺ thereby preparing Polymer A-1. Polymer A-1 thus-obtained had an Mw of 30,000, an acid value of 11.3 mmol/g, and a saponification degree of about 100% by mole.

### <Preparation Example of Polymer A-2>

In a predetermined amount of xylene were dissolved 75 g of ethyl α-acetoxyacrylate, 14 g of vinyl acetate and 2,2'-azobisisobutyronitrile (0.4% by mole based on the monomers) to prepare a solution (monomer concentration: 30% by weight). The solution was subjected to nitrogen bubbling for 10 minutes and then stirred at 60°C for 10 hours under nitrogen stream to progress a polymerization reaction. The reaction solution obtained was dissolved in 300 ml of dichloromethane and gradually added dropwise to 5 liters of methanol. A white polymer precipitated was collected by filtration and dried in a vacuum overnight to obtain a copolymer of ethyl α-acetoxyacrylate and vinyl acetate. A weight average molecular weight (Mw) of the copolymer obtained was 55,000.

The copolymer was dissolved in tetrahydrofuran and brought into contact with sodium hydroxide at 40°C to undergo a saponification reaction, and the resulting resin was washed with methanol soxhlet for 24 hours. The resulting resin was treated using a cation exchange resin to convert Na⁺ to H⁺ thereby preparing Polymer A-2. Polymer A-2 thus-obtained had an Mw of 25,000, an acid value of 9.4 mmol/g, and a saponification degree of about 100% by mole.

### <Preparation Example of Polymer A-8>

In a predetermined amount of xylene were dissolved 59 g of tert-butyl α-acetoxyacrylate, 17 g of acrylonitrile and 2,2'-azobisisobutyronitrile (0.4% by mole based on the monomers) to prepare a solution (monomer concentration: 30% by weight). The solution was subjected to nitrogen bubbling for 10 minutes and then stirred at 60°C for 10 hours under nitrogen stream to progress a polymerization reaction. The reaction solution obtained was dissolved in 300 ml of dichloromethane and gradually added dropwise to 5 liters of methanol. A white polymer precipitated was collected by filtration and dried in a vacuum overnight to obtain a copolymer of tert-butyl α-acetoxyacrylate and acrylonitrile. A weight average molecular weight (Mw) of the copolymer obtained was 58,000.

The copolymer was dissolved in xylene and subjected to decomposition of the tert-butyl ester using p-toluenesulfonic acid as a catalyst. Thus, Polymer A-8 was prepared. Polymer A-8 thus-obtained had an Mw of 31,000, and an acid value of 6.8 mmol/g.

A weight average molecular weight (Mw) of the polymer A for use in the invention is preferably from 5,000 to 1,000,000, more preferably from 10,000 to 750,000, and particularly preferably from 20,000 to 500,000. In the range described above, the oxygen-blocking property and development property are good.

In the coating composition according to the invention, the polymer A may be used only one kind or may be used as a mixture of two ore more kinds thereof.

The content of the polymer A in the coating composition according to the invention is preferably from 10 to 100% by weight, more preferably from 20 to 100% by weight, particularly preferably from 30 to 100% by weight, based on the total solid content of the coating composition.

The coating composition according to the invention may also contain an optional component in addition to the polymer A. The optional component will be described below.

### [Inorganic stratiform compound]

The coating composition according to the invention may contain an inorganic stratiform compound in order to increase the oxygen-blocking property. The inorganic stratiform compound is a particle having a thin tabular shape and includes, for instance, a mica, for example, natural mica or synthetic mica, talc represented by formula: 3MgO·4SiO·H₂O, taeniolite, montmorillonite, saponite, hectorite and zirconium phosphate.

The inorganic stratiform compound preferably used in the invention is a mica compound. The mica compound includes a mica, for example, natural mica represented by formula: A(B,C)₂₋₅D₄O₁₀(OH,F,O)₂, (wherein A represents any of K, Na and Ca, B and C each represents any of Fe (II), Fe(III), Mn, Al, Mg and V, and D represents Si or Al) or synthetic mica.

In the mica group, examples of the natural mica include muscovite, paragonite, phlogopite, biotite and lepidolite. Examples of the synthetic mica include non-swellable mica, for example, fluorphlogopite KMg₃(AlSi₃O₁₀)F₂ or potassium tetrasilicic mica KMg_{2.5}(Si₄O₁₀)F₂, and swellable mica, for example, Na tetrasilicic mica NaMg_{2.5}(Si₄O₁₀)F₂, Na or Li taeniolite (Na, Li)Mg₂Li(Si₄O₁₀)F₂ or montmorillonite-based Na or Li hectorite (Na, Li)_{1/8}Mg_{2/5}Li_{1/8}(Si4O₁₀)F₂. Synthetic smectite is also useful.

Of the mica compounds, fluorine based swellable mica is particularly useful in the invention. Specifically, the swellable synthetic mica has a stratiform structure comprising a unit crystal lattice layer having thickness of approximately from 10 to 15 angstroms, and metallic atom substitution in the lattices thereof is remarkably large in comparison with other clay minerals. As a result, the lattice layer results in lack of positive charge and in order to compensate it, a cation, for example, Li⁺, Na⁺, Ca²⁺ or Mg²⁺, is adsorbed between the lattice layers. The cation existing between the lattice layers is referred to as an exchangeable cation and is exchangeable with various cations. In particular, in the case where the cation between the lattice layers is Li⁺ or Na⁺, because of a small ionic radius, a bond between the stratiform crystal lattices is week, and the inorganic stratiform compound greatly swells upon contact with water. When share is applied under such a condition, the stratiform crystal lattices are easily cleaved to form a stable sol in water. The swellable synthetic mica has strongly such tendency and is particularly preferably used in the invention.

With respect to the shape of the mica compound, the thinner the thickness or the larger the plane size, so long as smoothness of coated surface and transmission of actinic radiation are not damaged, the better from the standpoint of control of diffusion. Therefore, an aspect ratio of the mica compound is ordinarily 20 or more, preferably 100 or more, and particularly preferably 200 or more. The aspect ratio is a ratio of major axis to thickness of particle and can be determined, for example, from a projection drawing of particle by a microphotography. The larger the aspect ratio, the greater the effect obtained.

As for the particle size of the mica compound, an average major axis is ordinarily from 0.3 to 20 µm, preferably from 0.5 to 10 µm, and particularly preferably from 1 to 5 µm. An average thickness of the particle is ordinarily 0.1 µm or less, preferably 0.05 µm or less, and particularly preferably 0.01 µm or less. Specifically, for example, in the swellable synthetic mica that is the representative compound, the thickness is approximately from 1 to 50 nm and the plane size (major axis) is approximately from 1 to 20 µm.

The content of the inorganic stratiform compound is preferably from 0 to 60% by weight, more preferably from 3 to 50% by weight, based on the total solid content of the coating composition. When a plural kind of the inorganic stratiform compounds is used together, it is preferred that the total amount of the inorganic stratiform compounds is in the range described above.

### [Crosslinking agent]

The coating composition according to the invention may contain a crosslinking agent in order to impart film strength. The crosslinking agent is particularly preferred in case of applying to a packaging film because it can impart strength and water resistance. As the crosslinking agent, a known crosslinking agent capable of reacting with a hydroxy group or a carboxy group can be used. Specific examples of the crosslinking agent include an aldehyde compound (for example, formaldehyde, glyoxal or glutaraldehyde), an amino resin (for example, a urea resin, a guanamine resin or a melamine resin), a methylol compound (for example, methylolated melamine, methylolated urea or methylolated bisphenol A), an epoxy compound (for example, a water-soluble epoxy resin, a polyamidopolyamine epichlorohydrin, ethylene glycol diglycidyl ether or triglycidyl isocyanurate), a hydrazide compound (for example, adipic dihydrazide, carbodihydrazide or polyhydrazide), an isocyanate compound (for example, hexamethylene diisocyanate, methylene bisphenyl isocyanate, isophorone diisocyanate or xylylene diisocyanate), a vinyl ether compound (for example, ethylene glycol divinyl ether, triethylene glycol divinyl ether or bis(2-vinyloxyethyl) succinate), boric acid, a borate (for example, borax), a titanium compound (for example, tetraalkoxy titanate), an aluminum compound (for example, aluminum sulfate, aluminum chloride or aluminum nitrate), a phosphorus compound (for example, a phosphite ester or bisphenol A-modified polyphosphoric acid), a silicone compound having a reactive group, for example, an alkoxy group or a glycidyl group, and a zirconium compound.

The content of the crosslinking agent is preferably from 0 to 50% by weight, more preferably from 3 to 40% by weight, based on the total solid content of the coating composition.

### [Other polymers]

In the coating composition according to the invention, a known technique can be used in order to increase uniformity of film or an adhesion property to a substrate. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on a photosensitive layer.

Any of these known techniques can be applied to the coating composition according to the invention so far as the effects of the invention are not impaired. For instance, the polymer A described above may be used together with polyvinyl pyrrolidone as the binder component from the standpoint of the adhesion property to the photosensitive layer or polymer film, sensitivity and prevention of undesirable fog. The weight ratio of the polymer A/polyvinyl pyrrolidone is preferably 3/1 or less.

Other than the polyvinyl pyrrolidone, a polymer relatively excellent in crystallizability, for example, acidic cellulose, gelatin, gum arabic, polyacrylic acid or copolymer of acrylic acid or polyvinyl alcohol (for example, polyvinyl alcohol, low-saponified polyvinyl alcohol, acid-modified polyvinyl alcohol, cation-modified polyvinyl alcohol or nonionic hydrophilic group-modified polyvinyl alcohol) may also be used together with the polymer A.

The content of the other polymer is preferably from 0 to 50% by weight, more preferably from 3 to 40% by weight, based on the total solid content of the coating composition.

### [Light-absorbing agent]

To the coating composition according to the invention may be added a light-absorbing agent (for example, a water-soluble dye), which is excellent in transmission of light used for exposure of the photosensitive layer and capable of efficiently absorbing light having a wavelength which does not concern the exposure. This allows increase in the safe light adaptability without accompanying decrease in the sensitivity.

The content of the light-absorbing agent is preferably from 0 to 50% by weight, more preferably from 3 to 40% by weight, based on the total solid content of the coating composition.

### [Inorganic fine particle]

To the coating composition according to the invention may be added an inorganic fine particle in order to control an abrasion property of surface. Examples of the inorganic fine particle include a silica gel particle or a titanium oxide particle. The content of the inorganic fine particle is preferably from 0 to 50% by weight, more preferably from 3 to 40% by weight, based on the total solid content of the coating composition.

### [Solvent]

The coating composition according to the invention also includes a form of solution or dispersion in which each component described above is dissolved or dispersed in a solvent. As the solvent, water is preferred from the standpoint of dissolving the polymer A. Ion-exchanged water is preferred as water. Also, in order to dissolve other components, an organic solvent may be added, if desired. Examples of the organic solvent include methanol, ethanol, isopropanol, 1-methoxy-2-propernol, benzyl alcohol, ethylene glycol, diethylene glycol, ethylene glycol monomethyl ether, ethylene glycol dimethyl ether, glycerin, 1-methoxy-2-acetoxypropane, tetrahydrofuran, acetone, cyclohexanone, methyl ethyl ketone, methyl isobutyl ketone, ethyl lactate, ethyl acetate, γ-butyrolactone, propylene carbonate, diethyl carbonate, dimethylformamide, dimethylacetamide, N-methylpyrrolidone, N-ethylpyrrolidone, N-butylpyrrolidone, tetramethylurea, 1,3-dimethyl-2-imidazolinone, dimethylsulfoxide, sulfolane, acetic acid and acetonitrile. The organic solvent used is preferably an organic solvent which is miscible with water in an amount of 1% by weight or more is preferred. A boiling point of the organic solvent is preferably 250°C or lower, more preferably 200°C or lower and particularly preferably 150°C or lower. The amount of the organic solvent added is preferably from 0 to 70% by weight, more preferably from 0 to 60% by weight and particularly preferably from 0 to 50% by weight.

### [Formation of coating using coating composition]

As to the coating composition according to the invention, each component described above is mixed with the polymer A molten and coated on a desired support followed by cooling to form a coating or each component is dissolved in a solvent and coated on a desired support followed by removing the solvent by evaporation to form a coating. The latter method is preferred in order to form a uniform and thin coating.

In the latter method, drying conditions for achieving a residual solvent amount of 10% by weight or less, preferably 5% by weight or less, more preferably 3% by weight or less, particularly preferably 1% by weight or less, are used. The drying temperature may be appropriately selected depending on the kind of solvent used and the intended use of the coating and is preferably from 10 to 300°C, more preferably from 20 to 280°C, and particularly preferably from 30 to 250°C. The drying time may be appropriately selected depending on the kind of solvent used and the intended use of the coating and is preferably from one second to 30 days, more preferably from 5 seconds to 15 days, and particularly preferably from 10 seconds to 7 days.

In the latter method, when the inorganic stratiform compound is incorporated into the coating composition, a dispersion of the inorganic stratiform compound is prepared and the dispersion is mixed with a solution containing each component, for example, the polymer A to prepare a coating solution or the inorganic stratiform compound is directly added to the solution containing each component, for example, the polymer A to prepare a coating solution.

An example of common dispersing method for the inorganic stratiform compound is described below. Specifically, from 5 to 10 parts by weight of a swellable mica compound which is preferably exemplified as the inorganic stratiform compound is added to 100 parts by weight of water to adapt sufficiently the compound to water and to be swollen, followed by dispersing using a dispersing machine. The dispersing machine used includes, for example, a variety of mills conducting dispersion by directly applying mechanical power, a high-speed agitation type dispersing machine providing a large shear force and a dispersion machine providing ultrasonic energy of high intensity. Specific examples of the dispersing machine include a ball mill, a sand grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having a Polman whistle. The dispersion containing from 2 to 15% by weight of the mica compound thus prepared is highly viscous or gelled and exhibits extremely good preservation stability.

To the coating solution can be added known additives, for example, a surfactant for improving coating property or a water-soluble plasticizer for improving physical property of coated layer. Examples of the surfactant include an anionic surfactant, for example, sodium alkylsulfate or sodium alkylsulfonate, an amphoteric surfactant, for example, alkylaminocarboxylate or alkylaminodicarboxylate and a nonionic surfactant, for example, polyoxyethylene alkyl phenyl ether. Examples of the water-soluble plasticizer include propionamide, cyclohexanediol, glycerin and sorbitol. Also, a water-soluble (meth)acrylic polymer may be added. Further, to the coating solution may be added known additives for increasing adhesion property to the photosensitive layer or for improving preservation stability of the coating solution.

A coating method of the coating solution according to the invention is not particularly limited, and methods described, for example, in U.S. Patent 3,458,311 and JP-B-55-49729 can be utilized.

### [Oxygen-blocking film]

In case of using the coating composition according to the invention for the oxygen-blocking film, the coating composition is coated according to the method described above on a film having mechanical strength and dimensional stability to use. A thickness of the layer formed from the coating composition is preferably in a range from 0.1 to 10 µm, and more preferably in a range from 0.5 to 10 µm.

Specific examples of the film include a polymer film, for instance, a polyester film, for example, a polyethylene terephthalate film, a polyethylene terephthalate-based copolymer polyester film or a polyethylene naphthalate film, a polyamide film, for example, nylon 66 film, a nylon 6 film or a metaxylidene diamine copolymer polyamide film, a polyolefin film, for example, a polypropylene film, a polyethylene film or a ethylene-propylene copolymer film, a polyimide film, a polyamideimide film, a polysulfone film, a polyphenylenesulfide film, a paper film, for example, paper or a polymer-coated paper, and a metal foil, for example an aluminum foil.

Various additives and stabilizers may be incorporated into the film or coated on the film as long as the effect of the invention is not impaired. Examples of the additive used include an antioxidant, an antistatic agent, an ultraviolet absorber, a plasticizer, a lubricant and a heat stabilizer. The film may be subjected to a surface treatment, for example, a corona treatment, a plasma treatment, a glow discharge treatment, an ion bombard treatment, a chemical treatment, a solvent treatment or a surface roughening treatment.

The thickness of the film is not particularly restricted because it can be appropriately selected considering an aptitude for the intended purpose, for example, a packaging material. From the standpoint of ordinary practical use, it is preferably in a range from 3 to 1,000 µm, and from the standpoint of flexibility and coating property of the coating composition, it is more preferably in a range from 10 to 300 µm.

The film provided with the coating composition thus-obtained is processed in a desired form of the packaging material through a known optional process (for example, laminating with other film or stacking of other layer).

### [Image-forming material]

Now, the image-forming material using the coating composition according to the invention is described taking a lithographic printing plate precursor as an example.

### [Lithographic printing plate precursor]

The coating composition according to the invention is used as a protective layer of a lithographic printing plate precursor having a photosensitive layer of radical polymerization type. <Photosensitive layer>

The photosensitive layer used in the lithographic printing plate precursor according to the invention contains (C) a photo initiator and (D) a radical polymerizable compound, and may contain (D) other optional components.

### (C) Photo initiator

The photosensitive layer according to the invention contains a photo initiator. In the invention, a radical polymerization initiator is preferably used.

As the photo initiator in the invention, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, onium salt compound, trihalomethyl compound and metallocene compound is preferred, and the hexaarylbiimidazole compound or the onium salt compound is particularly preferred. Two or more kinds of the photo initiators may be appropriately used in combination.

The hexaarylbiimidazole compound includes, for example, lophine dimers described in European Patents 24,629 and 107,792 and U.S. Patent 4,410,621, specifically, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-triffuoromethylphenyl)-4,4',5,5'-tetraphenylbiimidazole.

The hexaarylbiimidazole compound is particularly preferably used together with a sensitizing dye having an absorption maximum in a wavelength range from 300 to 450 nm.

The onium salt compound preferably used in the invention includes a sulfonium salt, an iodonium salt and a diazonium salt. Particularly, a diaryliodonium salt or a triarylsulfonium salt is preferably used. The onium salt compound is particularly preferably used together with an infrared absorbing agent having an absorption maximum in a wavelength range from 750 to 1,400 nm.

In addition, polymerization initiators described in Paragraph Nos. [0071] to [0129] of JP-A-2007-206217 are preferably used as the photo initiator.

The photo initiators are preferably used individually or in combination of two or more thereof according to the invention.

The amount of the photo initiator used in the photosensitive layer according to the invention is preferably from 0.01 to 20% by weight, more preferably from 0.1 to 15% by weight, still more preferably from 1.0 to 10% by weight, based on the total solid content of the photosensitive layer.

### (D) Radical polymerizable compound

The radical polymerizable compound for use in the photosensitive layer according to the invention is an addition-polymerizable compound having at least one ethylenically unsaturated double bond and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group, with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. These compounds are described in references including JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (2) shown below to a polyisocyanate compound having two or more isocyanate groups per molecule, described in JP-B-48-41708.

CH₂=C(R⁴)COOCH₂CH(R⁵)OH (2)

wherein R⁴ and R⁵ each independently represents H or CH₃.

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, for the lithographic printing plate precursor of on-press development type, an isocyanuric acid ethyleneoxide-modified acrylate, for example, tris(acryloyloxyethyl) isocyanurate or bis(acryloyloxyethyl) hydroxyethyl isocyanurate is particularly preferred from the standpoint of excellent balance between hydrophilicity relating to the on-press development property and polymerization ability relating to the printing durability of a lithographic printing plate prepared from the lithographic printing plate precursor.

Details of the method of using the radical polymerizable compound, for example, selection of the structure, individual or combination use or an amount added, can be appropriately determined in accordance with the characteristic design of the final lithographic printing plate precursor. The radical polymerizable compound is used preferably in a range from 5 to 75% by weight, more preferably in a range from 25 to 70% by weight, particularly preferably in a range from 30 to 60% by weight, based on the total solid content of the photosensitive layer.

### (E) Other components

The photosensitive layer for use in the invention may contain a binder polymer, a sensitizing dye or the like in addition to the photo initiator and radical polymerizable compound described above.

### (Binder polymer)

As the binder polymer, a polymer capable of holding the components of photosensitive layer on a support and capable of being removed with a developer or with at least one of dampening water and ink on a printing machine is used. The binder polymer used includes, for example, a (meth)acrylic polymer, a polyurethane resin, a polyvinyl alcohol resin, a polyvinyl butyral resin, a polyvinyl formal resin, a polyamide resin, a polyester resin and an epoxy resin. Particularly, a (meth)acrylic polymer or a polyurethane resin is preferably used. The resin may have any of a straight-chain, graft or star-like form. Also, the constituting component of the resin may be a random or block form.

The term "(meth)acrylic polymer" as used herein means a copolymer containing as a polymerization component, (meth)acrylic acid or a (meth)acrylic acid derivative, for example, a (meth)acrylate (including, for example, an alkyl ester, an aryl ester and an allyl ester), (meth)acrylamide or a (meth)acrylamide derivative. The term "polyurethane resin" as used herein means a polymer formed by a condensation reaction of a compound having two or more isocyanate groups and a compound having two or more hydroxy groups. The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and includes a polymer wherein an acid group or the like is introduced by a method of reacting the remaining hydroxy group of polymer with a compound having the acid group or the like.

One preferred example of the binder polymer capable of being removed with a developer according to the invention is a copolymer containing a repeating unit having an acid group. Examples of the acid group include a carboxylic acid group, a sulfonic acid group, a phosphonic acid group, a phosphoric acid group, a phenolic hydroxy group and a sulfonamido group. Particularly, a carboxylic acid group is preferred. As the repeating unit having an acid group, a repeating unit derived from (meth)acrylic acid or a repeating unit represented by formula (3) shown below is preferably used.

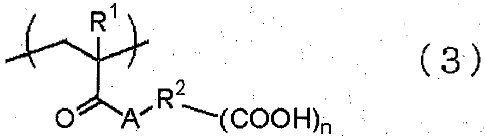

In formula (3), R¹ represents a hydrogen atom or a methyl group, R² represents a single bond or an n+1 valent connecting group, A represents an oxygen atom or NR³-, wherein R³ represents a hydrogen atom or a monovalent hydrocarbon group having from 1 to 10 carbon atoms, and n represents an integer from 1 to 5.

The connecting group represented by R² in formula (3) is constructed from a carbon atom, a hydrogen atom, an oxygen atom, a nitrogen atom, a sulfur atom and a halogen atom and a number of the atoms included is preferably from 1 to 80. Specific examples of the connecting group include an alkylene group, a substituted alkylene group, an arylene group and a substituted arylene group. The connecting group may have a structure wherein a plurality of such divalent groups is connected to each other via an amido bond or an ester bond. R² is preferably a single bond, an alkylene group or a substituted alkylene group, particularly preferably a single bond, an alkylene group having from 1 to 5 carbon atoms or a substituted alkylene group having from 1 to 5 carbon atoms, and most preferably a single bond, an alkylene group having from 1 to 3 carbon atoms or a substituted alkylene group having from 1 to 3 carbon atoms.

Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, particularly preferably a hydrogen atom or a hydrocarbon group having from 1 to 3 carbon atoms, and most preferably a hydrogen atom or a methyl group. n is preferably from 1 to 3, particularly preferably 1 or 2, and most preferably 1.

A ratio of the copolymerization component having a carboxylic acid group in the total copolymerization component of the binder polymer is preferably from 1 to 70% by mole in view of development property. Considering good compatibility between the development property and printing durability of a lithographic printing plate prepared from the lithographic printing plate precursor, it is more preferably from 1 to 50% by mole, and particularly preferably from 1 to 30% by mole. '

One preferred example of the binder polymer capable of being removed with at least one of dampening water and ink on a printing machine according to the invention is a copolymer containing a repeating unit having a hydrophilic group. Examples of the hydrophilic group include a carboxylic acid (salt) group, a sulfonic acid (salt) group, a hydroxy group, a carbonamido group, a sulfuric acid (salt) group, a carbobetaine group, a sulfobetaine group, a phosphobetaine group, an N-oxide group, an ammonium group, -(CH₂CH₂O)ₙR, -(C₃H₆O)ₘR (wherein R represents a hydrogen atom, an alkyl group having from 1 to 12 carbon atoms, an aryl group, an alkenyl group or an alkynyl group, and n and m each represents an integer from 1 to 100), and a combination of these groups. Of the hydrophilic groups, a sulfonic acid (salt) group, a hydroxy group, a carbonamido group, a carbobetaine group, a sulfobetaine group, a phosphobetaine group or -(CH₂CH₂O)ₙR is more preferred, and a carbonamido group or -(CH₂CH₂O)ₙR is particularly preferred.

A ratio of the copolymerization component having a hydrophilic group in the total copolymerization component of the binder polymer is preferably from 1 to 70% by mole in view of development property. Considering good compatibility between the development property and printing durability of a lithographic printing plate prepared from the lithographic printing plate precursor, it is more preferably from 1 to 60% by mole, and particularly preferably from 1 to 50% by mole.

It is preferred that the binder polymer for use in the invention further contains a crosslinkable group. The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of fomihig a radical upon irradiation with light may be used and such a crosslinkable group includes, for example, a thiol group and a halogeno group. Among them, the ethylenically unsaturated bond group is preferred. The ethylenically unsaturated bond group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause an addition-polymerization between the polymers directly or through a polymerization chain of the polymerizable compound, as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, and most preferably from 0.1 to 2.0 mmol, per g of the binder polymer.

The binder polymer for use in the invention may contain a polymerization unit of alkyl (meth)acrylate or aralkyl (meth)acrylate besides the polymerization unit having an acid group and the polymerization unit having a crosslinkable group. The alkyl group in the alkyl (meth)acrylate is preferably an alkyl group having from 1 to 5 carbon atoms and more preferably a methyl group. The aralkyl (meth)acrylate includes, for example, benzyl (meth)acrylate.

The binder polymer preferably has a weight average molecular weight (Mw) of 5,000 or more, more preferably from 10,000 to 300,000, and a number average molecular weight (Mn) of 1,000 or more, more preferably from 2,000 to 250,000. The polydispersity (Mw/Mn) is preferably from 1.1 to 10.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer, from the standpoint of good strength of the image area and good image-forming property.

The total content of the radical polymerizable compound and the binder polymer is preferably 80% by weight or less based on the total solid content of the photosensitive layer. When the total content exceeds 80% by weight, decrease in the sensitivity and deterioration of the development property may be caused in some cases. The total content is more preferably from 35 to 75% by weight.

### (Sensitizing dye)

The photosensitive layer according to the invention preferably contains a sensitizing dye. The sensitizing dye can be used without particular limitation so far as it absorbs light at the image exposure to form the excited state and provides energy to the photo initiator with electron transfer, energy transfer or heat generation thereby improving the polymerization initiation function. Particularly, a sensitizing dye having an absorption maximum in a wavelength range from 300 to 450 nm or from 750 to 1,400 nm is preferably used.

Examples of the sensitizing dye having an absorption maximum in a wavelength range from 300 to 450 nm include merocyanine dyes, benzopyranes, coumarins, aromatic ketones, anthracenes, styryls and oxazoles.

Of the sensitizing dyes having an absorption maximum in a wavelength range from 300 to 450 nm, a dye represented by formula (4) shown below is more preferred in view of high sensitivity.

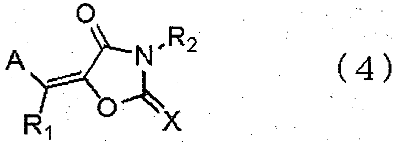

In formula (4), A represents an aryl group which may have a substituent or a heteroaryl group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

The formula (4) will be described below. The monovalent non-metallic atomic group represented by any of R₁, R₂ and R₃ preferably includes a hydrogen atom, a substituted or unsubstituted alkyl group (for example, a methyl group, an ethyl group, a propyl group, a benzyl group, a chloroethyl group, a hydroxyethyl group, a methoxyethyl group, a dimethylaminoethyl group or a 2-ketopropyl group), a substituted or unsubstituted alkenyl group (for example, a vinyl group, a propenyl group or a 2-phenylvinyl group), a substituted or unsubstituted aryl group (for example, a phenyl group, a naphthyl group, a 4-chlorophenyl group, a 2-hydroxyphenyl group, a 4-methoxyphenyl group, a 4-carboxyphenyl group or a 4-dimethylaminophenyl group), a substituted or unsubstituted heteroaryl group (for example, a 4-pyridyl group or a pyrrole group), a substituted or unsubstituted alkoxy group (for example, a methoxy group, an ethoxy group, a propoxy group, an isopropyloxy group, a 2-methoxyethoxy group, a 2-chloroethoxy group or a 2-phenylethoxy group), a substituted or unsubstituted aryloxy group (for example, a phenoxy group, a naphthyloxy group, a 2-chlorophenyloxy group, a 4-methoxyphenyloxy group, a 4-carboxyphenyloxy group, a 2-methoxycarbonylphenyloxy group, a 4-(N,N-dimethylaminocarbonyl)phenyloxy group), a substituted or unsubstituted alkylthio group (for example, a methylthio group or an ethylthio group), a hydroxy group and a halogen atom. Specific examples of the aryl group which may have a substituent or heteroaryl group which may have a substituent represented by A include a phenyl group, a naphthyl group, a 4-diphenylaminophenyl group, a 4-diethylaminophenyl group, a 4-methoxyphenyl group, a 2-pyridyl group and a 4-pyridyl group.

Specific examples of such a sensitizing dye preferably used include compounds described in Paragraph Nos. [0047] to [0053] of JP-A-2007-58170, Paragraph Nos. [0036] to [0037] of JP-A-2007-93866 and Paragraph Nos. [0042] to [0047] of JP-A-2007-72816.

Further, sensitizing dyes described in JP-A-2006-189604, JP-A-2007-171406, JP-A-2007-206216, JP-A-2007-206217, JP-A-2007-225701, JP-A-2007-225702, JP-A-2007-316582 and JP-A-2007-328243 are also preferably used.

The sensitizing dyes may be used only one kind or in combination of two or more kinds thereof.

Next, the sensitizing dye having an absorption maximum in a wavelength range from 750 to 1,400 (hereinafter, also referred to as an "infrared absorbing agent") preferably used in the invention is described in detail below. The infrared absorbing agent used is preferably a dye or a pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferred examples of the dye, cyanine dyes represented by formula (a) shown below are exemplified.
Formula (a):

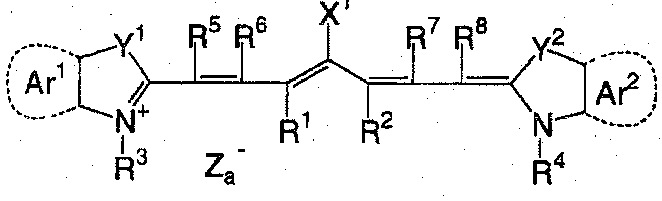

In formula (a), X¹ represents a hydrogen atom, a halogen atom, -N(R⁹)(R¹⁰), -X²-L¹ or a group shown below. R⁹ and R¹⁰, which may be the same or different, each represents an aromatic hydrocarbon group having from 6 to 10 carbon atoms, which may have a substituent, an alkyl group having from 1 to 8 carbon atoms or a hydrogen atom, or R⁹ and R¹⁰ may be combined with each other to from a ring, and preferably represents a phenyl group. X² represents an oxygen atom or a sulfur atom, L¹ represents a hydrocarbon group having from 1 to 12 carbon atoms, an aromatic cyclic group containing a hetero atom (a nitrogen atom, a sulfur atom, an oxygen atom, a halogen atom or a selenium atom) or a hydrocarbon group having from 1 to 12 carbon atoms and containing a hetero atom. In the group shown below, Xa⁻ has the same meaning as Za⁻ defined hereinafter, and R^{a} represents a hydrogen atom or a substituent selected from an alkyl group, an aryl group, a substituted or unsubstituted amino group and a halogen atom.

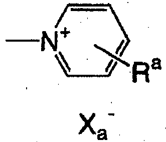

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms. Also, R¹ and R² may be combined with each other to form a ring and in case of forming the ring, to form a 5-membered or 6-membered ring is particularly preferred.

Ar¹ and Ar², which may be the same or different, each represents an aryl group which may have a substituent. Preferred examples of the aryl group include a benzene ring group and a naphthalene ring group. Preferred examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferred examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (a) has an anionic substituent in the structure thereof and the neutralization of charge is not needed. Preferred examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer. As the counter ion, that containing no halide ion is particularly preferred.

Specific examples of the cyanine dye represented by formula (a) preferably used include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of JP-A-2008-195018, and particularly preferably compounds described in Paragraph Nos. [0035] to [0043] of JP-A-2007-90850.

Further, compounds described in Paragraph Nos. [0008] to [0009] of JP-A-5-5005 and Paragraph Nos. [0022] to [0025] of JP-A-2001-222101 are also preferably used.

The infrared absorbing dyes may be used only one kind or in combination of two or more kinds thereof and may be used together with an infrared absorbing agent other than the infrared absorbing dye, for example, a pigment. As the pigment, compounds described in Paragraph Nos. [0072] to [0076] of JP-A-2008-195018 are preferred.

The amount of the sensitizing dye added is preferably from 0.05 to 30 parts by weight, more preferably from 0.1 to 20 parts by weight, particularly preferably from 0.2 to 10 parts by weight, based on 100 parts by weight of the total solid content of the photosensitive layer.

### (Other components of photosensitive layer)

Into the photosensitive layer according to the invention, various additives can be further incorporated, if desired. Examples of the additive used include a surfactant for progressing the development property and improving the surface state of coated layer, a coated surface state improving agent, a microcapsule for providing good compatibility between the development property and the printing durability of a lithographic printing plate prepared from the lithographic printing plate precursor, a hydrophilic polymer for improving the development property and dispersion stability of microcapsule, a coloring agent or print-out agent for visually distinguishing the image area from the non-image area, a polymerization inhibitor for preventing undesirable thermal polymerization of the radical polymerizable compound during the production or preservation of the photosensitive layer, a hydrophobic low molecular weight compound, for example, a higher fatty acid derivative for avoiding polymerization inhibition due to oxygen, a fine inorganic particle for increasing strength of the cured layer in the image area, a fine organic particle, a hydrophilic low molecular weight compound for improving the development property, a co-sensitizer or chain transfer agent for increasing sensitivity, a plasticizer for improving plasticity, and an oil-sensitizing agent, for example, a phosphonium compound, a nitrogen-containing low molecular weight compound or an ammonium group-containing polymer, for improving ink receptivity. As the additives, known compounds can be used and, for example, compounds described in Paragraph Nos. [0161] to [0215] of JP-A-2007-206217, Paragraph No. [0067] of JP-T-2005-509192, Paragraph Nos. [0023] to [0026] and [0059] to [0066] of JP-A-2004-310000, Paragraph Nos. [0222] to [0231] of JP-A-2009-29124, Paragraph Nos. [0039] to [0042] of JP-A-2007-50660, Paragraph Nos. [0021] to [0037] of JP-A-2008-284858, Paragraph Nos. [0030] to [0057] of JP-A-2009-90645 and Paragraph Nos. [0089] to [0105] of JP-A-2009-208458 are used. With respect to the surfactant, surfactants which may be added to a developer described hereinafter may be used.

The photosensitive layer preferably contains a chain transfer agent. The chain transfer agent is defined, for example, in Kobunshi Jiten (Polymer Dictionary), Third Edition, pages 683 to 684, edited by The Society of Polymer Science, Japan (2005). As the chain transfer agent, for example, compounds having SH, PH, SiH or GeH in their molecules are used. The compound donates a hydrogen to a low active radical species to generate a radical or is oxidized and then deprotonized to generate a radical. In the photosensitive layer according to the invention, a thiol compound (for example, a 2-mercaptobenzimidazole, a 2-mercaptobenzothiazole, a 2-mercaptobenzoxazole, a 3-mercaptotriazole or a 5-mercaptotetrazole) is preferably used.

The content of the chain transfer agent is preferably from 0.01 to 20 parts by weight, more preferably in a range from 1 to 10 parts by weight, most preferably from 1 to 5 parts by weight, per 100 parts by weight of the total solid content of the photosensitive layer.

### [Formation of photosensitive layer]

The photosensitive layer according to the invention is formed by dispersing or dissolving each of the necessary components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer on the support after the coating and drying is preferably from 0.3 to 3.0 g/m². Various methods can be used for the coating. Examples of the method include bar coater coating, spin coating, spray coating, curtain coating, dip coating, air knife coating, blade coating and roll coating.

### <Support>

The support for use in the lithographic printing plate precursor according to the invention is not particularly restricted so far as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 can be preferably used.

The support preferably has center line average roughness from 0.10 to 1.2 µm. In the range described above, good adhesion property to the photosensitive layer and good printing durability and good resistance to stain of a lithographic printing plate prepared from the lithographic printing plate precursor are achieved.

Also, the color density of the support is preferably from 0.15 to 0.65 in terms of the reflection density value. In the range described above, good image-forming property by prevention of halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

### [Hydrophilizing treatment of support and undercoat layer]

As for the lithographic printing plate precursor according to the invention, in order to increase hydrophilicity of the non-image area and to prevent printing stain, it is preferred to conduct hydrophilizing treatment for the surface of support or to provide an undercoat layer between the support and the photosensitive layer.

The hydrophilizing treatment for the surface of support includes an alkali metal silicate treatment method wherein the support is subjected to an immersion treatment or an electrolytic treatment in an aqueous solution, for example, of sodium silicate, a method of treating with potassium fluorozirconate and a method of treating with polyvinylphosphonic acid. A method of immersion treatment in an aqueous polyvinylphosphonic acid solution is preferably used.

As the undercoat layer, an undercoat layer containing a compound having an acid group or a salt thereof, for example, a phosphonic acid group or a salt thereof, a phosphoric acid group or a salt thereof or a sulfonic acid group or a salt thereof is preferably used. The compound preferably further has a polymerizable group in order to improve the adhesion property to the photosensitive layer. As the polymerizable group, an ethylenically unsaturated bond group is preferred. Further, a compound having a hydrophilicity-imparting group, for example, an ethylene oxide group is exemplified as a preferred compound.

These compounds may be low molecular weight compounds or polymer compounds. Also, these compounds may be used as a mixture of two or more thereof, if desired.

Specifically, a silane coupling agent having an addition-polymerizable ethylenically unsaturated bond group described in JP-A-10-282679 and a phosphorus compound having an ethylenically unsaturated bond group described in JP-A-2-304441 are preferably exemplified. Low molecular weight compounds or polymer compounds having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263 are also preferably used.

The undercoat layer can be coated by a known method. The coating amount (solid content) of the undercoat layer is preferably from 0.1 to 100 mg/m², and more preferably from 1 to 30 mg/m².

### <Backcoat layer>

A backcoat layer can be provided on the back surface of the support after conducting the surface treatment to the surface of support or forming the undercoat layer on the surface of support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred because the starting materials are inexpensive and easily available.

The coating composition according to the invention is coated in the manner as described above on the photosensitive layer on the support to prepare a lithographic printing plate precursor.

### [Plate making method]

The plate making method of the lithographic printing plate precursor according to the invention is preferably a method including at least a step of imagewise exposing the lithographic printing plate precursor (hereinafter, also referred to as an "exposure step") and a step of development processing of the lithographic printing plate precursor with a processing solution (hereinafter, also referred to as a "development step").

### [Exposure step]

Although the lithographic printing plate precursor for use in the invention can be subjected to image recording by a method of scanning exposure of digital data by laser, for example, visible laser or infrared laser or a method of exposing through a transparent original having an image recorded using a light source, for example, a halogen lamp or a high pressure mercury lamp, the method of scanning exposure of digital data by laser, for example, visible laser or infrared laser is preferred.

The wavelength of the exposure light source is preferably from 300 to 450 nm or from 750 to 1,400 nm. In case of exposing with light of 300 to 450 nm, the lithographic printing plate precursor having a photosensitive layer containing a sensitizing dye having an absorption maximum in such a wavelength range is used. In case of exposing with light of 750 to 1,400 nm, the lithographic printing plate precursor containing an infrared absorbing agent which is a sensitizing dye having an absorption maximum in such a wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

### [Development step]

After the exposure, the lithographic printing plate precursor according to the invention may be developed with water or an aqueous alkaline solution (processing with developer) or developed with dampening water and ink on a printing machine (on-press development).

The processing with developer is ordinarily practiced according to the following steps: (1) removing the non-image area with a developer, (2) conducting gumming solution treatment and (3) drying in a drying step. Although the lithographic printing plate precursor for use in the invention can be developed according to the conventional steps described above (conventional development), it is preferred to conduct steps (1) and (2) simultaneously (simple development). In any of the development methods, a water washing step for removing a protective layer may be provided before step (1). The development of step (1) is conducted according to a conventional manner at temperature approximately from 0 to 60°C, preferably from 15 to 40°C, using, for example, a method wherein the imagewise exposed lithographic printing plate precursor is immersed in a developer and rubbed with a brush or a method wherein a developer is sprayed to the imagewise exposed lithographic printing plate precursor by a spray and the lithographic printing plate precursor is rubbed with a brush.

In case of the conventional development, a water washing step for removing an excess developer may be provided between step (1) and step (2). The developer used in step (1) is preferably a known alkali developer.

In case of the simple development, it is preferred that after the development and gumming treatment, an excess developer is removed using a squeeze roller and then drying is conducted.

The developer for use in the simple development is an aqueous solution having pH from 2 to 11. An aqueous solution containing water as the main component (containing 60% by weight or more of water) is preferred. In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is preferably from 5 to 10.7, more preferably from 6 to 10.5, and most preferably from 7.5 to 10.3.

The anionic surfactant for use in the developer for the simple development is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylalkylsulfonic acid salts, polyoxyethylene alkylsulfophenyl ether salts, N-methylalkyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer for the simple development is not particularly limited and conventionally known cationic surfactants can be used. Examples of the cationic surfactant include alkylamine salts, quaternary ammonium salts, alkylimidazolinium salts, polyoxyethylene alkyl amine salts and polyethylene polyamine derivatives.

The nonionic surfactant for use in the developer for the simple development is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred and alkyl-substituted or unsubstituted phenol ethylene oxide adducts and alkyl-substituted or unsubstituted naphthol ethylene oxide adducts are more preferred.

The amphoteric surfactant for use in the developer for the simple development is not particularly limited and includes, for example, amine oxide type, for example, alkyldimethylamine oxide, betaine type, for example, alkyl betaine, and amino acid type, for example, sodium salt of alkylamino fatty acid. In particular, alkyldimethylamine oxide which may have a substituent, alkyl carboxy betaine which may have a substituent and alkyl sulfo betaine which may have a substituent are preferably used. Specific examples of the amphoteric surfactant include those described in Paragraph Nos. [0255] to [0278] of JP-A-2008-203359, Paragraph Nos. [0023] to [0052] of JP-A-2008-276166 and Paragraph Nos. [0022] to [0029] of JP-A-2009-47927.

Two or more of the surfactants may be used in combination. The content of the surfactant in the developer is preferably from 0.01 to 20% by weight, and more preferably from 0.1 to 10% by weight.

The water-soluble polymer compound for use in the developer for the simple development includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer, a styrene/maleic anhydride copolymer, polyvinylsulfonic acid or a salt thereof and polystyrenesulfonic acid or a salt thereof.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range from 10 to 100 mPa/sec in the aqueous 10% by weight solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

Into the developer for use in the simple development, a pH buffer agent may further be incorporated.

As the pH buffer agent according to the invention, any pH buffer agent exhibiting a pH buffer function at pH from 2 to 11 can be preferably used. In the invention, a weak alkaline buffer agent is preferably used and includes, for example, (a) a carbonate ion and a hydrogen carbonate ion, (b) a borate ion, (c) a water-soluble amine compound and an ion of the water-soluble amine compound, and combinations thereof. Specifically, for example, (a) a combination of a carbonate ion and a hydrogen carbonate ion, (b) a borate ion, or (c) a combination of a water-soluble amine compound and an ion of the water-soluble amine compound exhibits a pH buffer function in the developer to prevent fluctuation of the pH even when the developer is used for a long period of time. As a result, for example, the deterioration of development property resulting from the fluctuation of pH and the occurrence of development scum are restrained. The combination of a carbonate ion and a hydrogen carbonate ion is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof.

When the combination of (a) a carbonate ion and a hydrogen carbonate ion is adopted as the pH buffer agent, the total amount of the carbonate ion and hydrogen carbonate ion is preferably from 0.05 to 5 mole/l, more preferably from 0.10 to 2 mole/l, particularly preferably from 0.20 to 1 mole/l, in the developer.

The developer for use in the simple development may contain an organic solvent. As the organic solvent to be contained, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide or N-methylpyrrolidone). Two or more organic solvents may be used in combination.

Further, when the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer according to the invention may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer described above can be used as a developer and a development replenisher for the exposed negative lithographic printing plate precursor and it is preferably applied to an automatic processor described hereinafter. In the case of conducting the development processing using an automatic processor, the developer becomes fatigued in accordance with the processing amount, and hence the processing ability may be restored using a replenisher or a fresh developer.

The development processing using the developer having pH from 2 to 11 according to the invention is preferably performed by an automatic processor equipped with a supplying means for the developer and a rubbing member. An automatic processor using a rotating brush roll as the rubbing member is particularly preferred. Further, the automatic processor is preferably provided with a means for removing the excess developer, for example, a squeeze roller or a drying means, for example, a hot air apparatus, subsequently to the development processing means.

In addition, in the plate making process of preparing a lithographic printing plate from the lithographic printing plate precursor according to the invention, the lithographic printing plate precursor may be heated its entire surface before or during the exposure or between the exposure and the development, if desired. By the heating, the image-forming reaction in the photosensitive layer is accelerated and advantages, for example, improvements in the sensitivity and stabilization of the sensitivity and the printing durability of a lithographic printing plate prepared from the lithographic printing plate precursor are achieved. For the purpose of increasing the image strength and printing durability of a lithographic printing plate prepared from the lithographic printing plate precursor, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions. Ordinarily, the heat treatment is carried out in a temperature range from 100 to 500°C. When the temperature is too low, a sufficient effect of strengthening the image may not be obtained, whereas when it is excessively high, problems of deterioration of the support and thermal decomposition of the image area may occur sometimes.

The lithographic printing plate precursor according to the invention can also be subjected to the plate making by an on-press development method. The on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the lithographic printing plate precursor is removed in the course of the printing step. The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing step. Then, the printing operation is initiated using the printing machine with supplying oily ink and an aqueous component and at an early stage of the printing the on-press development is carried out. Specifically, the photosensitive layer in the unexposed area is removed and the hydrophilic surface of support is revealed therewith to form the non-image area. As the oily ink and aqueous component, printing ink and dampening water for conventional lithographic printing can be employed, respectively.

While either the dampening water or printing ink may be supplied at first on the surface of lithographic printing plate precursor, it is preferred to supply the printing ink at first in view of preventing the dampening water from contamination with the component of the photosensitive layer removed.

Thus, the lithographic printing plate precursor according to the invention is subjected to the on-press development on an offset printing machine and used as it is for printing a large number of sheets.

### EXAMPLES

The present invention will be described in more detail with reference to the following examples, but the invention should not be construed as being limited thereto. I. Preparation and Evaluation of Lithographic printing plate precursor

In Examples 1 to 25 shown below, preparation and evaluation of a lithographic printing plate precursor in which the coating composition according to the invention is used in a protective layer will be described. Evaluation of image strength of a lithographic printing plate prepared from the lithographic printing plate precursor was conducted by evaluating printing durability. Ordinarily, it can be said that the image strength is higher, as the printing durability is higher.

### Examples 1 and 2 and Comparative Example 1

### [Preparation of Support]

An aluminum plate of JIS A 1050 having a thickness of 0.30 mm and a width of 1,030 mm was continuously subjected to surface treatment shown below.
(a) An etching treatment of the aluminum plate was conducted by spraying an aqueous solution having sodium hydroxide concentration of 2.6% by weight, aluminum ion concentration of 6.5% by weight and temperature of 70°C to dissolve the aluminum plate in an amount of 0.3 g/m². Subsequently, the plate was washed with water by spraying.
(b) A desmut treatment of the aluminum plate was conducted by spraying an aqueous 1% by weight nitric acid solution (containing 0.5% by weight of aluminum ion) having temperature of 30°C. Subsequently, the plate was washed with water by spraying.
(c) An electrochemical surface roughening treatment of the aluminum plate was continuously conducted by using 60 Hz alternating current voltage. The electrolytic solution used was an aqueous 1% by weight nitric acid solution. The electrolytic solution contained 0.5% by weight of aluminum ion and 0.007% by weight of acetic acid. The solution temperature was 21 °C. The electrochemical surface roughening treatment was conducted using a sinusoidal wave alternating current where time (TP) for reaching the current to its peak from zero was 2 msec as an alternating current source and using a carbon electrode as a counter electrode. The current density was 50 A/dm² in terms of an effective value, and the electric quantity was 900 C/dm². Subsequently, the plate was washed with water by spraying.
(d) A desmut treatment of the aluminum plate was conducted with an aqueous 20% by weight phosphoric acid solution (containing 0.5% by weight of aluminum ion) having temperature of 60°C for 10 seconds. Subsequently, the plate was washed with water by spraying.
(e) An anodizing treatment of the aluminum plate was conducted by an existing anodizing apparatus according to a two-stage feeding electrolytic treatment method (length of each of a first electrolytic unit and a second electrolytic unit: 6 m; length of each of a first feeding unit and a second feeding unit: 3 m; length of each of a first feeding electrode and a second feeding electrode: 2.4 m) using an aqueous solution having sulfuric acid concentration of 170 g/liter (containing 0.5% by weight of aluminum ion) of temperature of 38°C in the electrolytic units. Subsequently, the plate was washed with water by spraying. During the anodizing treatment, in the anodizing apparatus an electric current from a power source flowed to the first feeding electrode placed in the first feeding unit and through the electrolytic solution to the aluminum plate to form an anodized film on the surface of aluminum plate in the first electrolytic unit, and then passed through an electrolysis electrode placed in the first feeding unit and returned to the power source. On the other hand, an electric current from the power source flowed to the second feeding electrode placed in the second feeding unit and in the same manner as described above through the electrolytic solution to the aluminum plate to form an anodized film on the surface of aluminum plate in the second electrolytic unit. The quantity of electricity fed from the power source to the first feeding unit was same as that fed from the power source to the second feeding unit, and the fed current density on the anodized film surface in the second feeding unit was about 25 A/dm². In the second feeding unit, the current was fed from the anodized film surface of 1.35 g/m². The amount of the final anodized film was 2.7 g/m². After the washing with water by spraying, the aluminum plate was immersed in a 0.4% by weight polyvinylphosphonic acid solution for 30 seconds to perform a hydrophilizing treatment. The solution temperature was 75°C. Subsequently, the plate was washed with water by spraying and dried by an infrared heater. A center line average roughness (Ra) of the surface was 0.55 µm.

### [Preparation of Photosensitive layer and Protective layer]

Coating solution 1 for photosensitive layer having the composition shown below was coated on the support described above by a wire bar so as to have a dry coating amount of 1.5 g/m² and dried at 95°C for 1.5 minutes to obtain a photosensitive layer coating sample.

### (Coating solution 1 for photosensitive layer)

| | |
|---|---|
| Radical polymerizable compound 1 having structure shown below | 27.0 parts by weight |
| Radical polymerizable compound (NK ESTER 4G, produced by Shin-Nakamura Chemical Co., Ltd.) | 14.0 parts by weight |
| Sensitizing dye (dye-1) having structure shown below | 3.0 parts by weight |
| Photo initiator (titanocene compound) having structure shown below | 2.0 parts by weight |
| Photo initiator (Co-initiator (K-1) having structure shown below | 2.0 parts by weight |
| Binder polymer (Acrylic copolymer 1, Mw: 90,000) having structure shown below | 45.0 parts by weight |
| Phthalocyanine pigment (MHI 454, produced by Mikuni Color Ltd.) | 6.0 parts by weight |
| Polymerization inhibitor ([2-tert-Butyl-6-(3-tert-butyl-2-hydroxy-5-methylbenzyl)-4-methylphen yl acrylate (SUMILIZER GS, produced by Sumitomo 3M Corp.) | 0.5 parts by weight |
| Fluorine-based surfactant (FC-4430, produced by Sumitomo 3M Corp.) | 0.5 parts by weight |
| Siloxane-based surfactant (BYK 337, produced by BYK-Chemie GmbH) | 0.9 parts by weight |
| Methyl ethyl ketone | 80 parts by weight |
| Propylene glycol monomethyl ether | 820 parts by weight |

### Radical polymerizable compound 1:

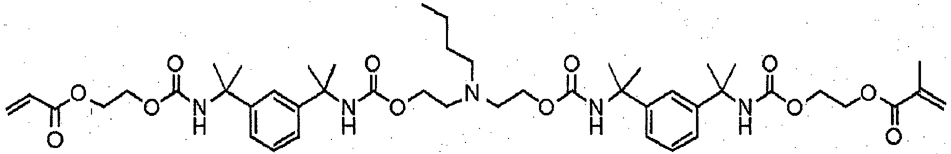

Photo initiator (titanocene compound): 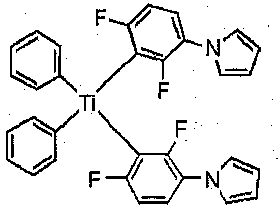 Photo initiator (Co-initiator (K-1)): 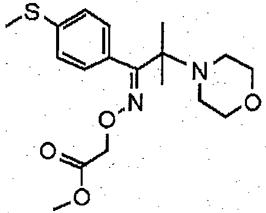 Sensitizing dye (dye-1): 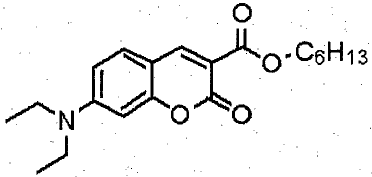 Acrylic copolymer 1:

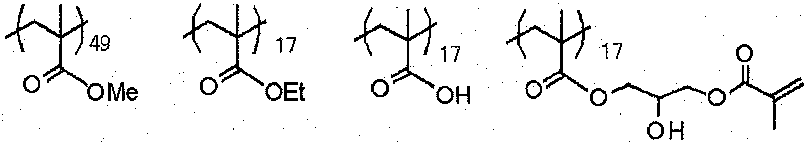

Coating solution 1 for protective layer having the composition shown below was coated on the photosensitive layer coating sample by a wire bar so as to have a dry coating amount of 1.8 g/m² and dried at 75°C for 1.5 minutes to prepare Lithographic printing plate precursor (1) having a protective layer on the photosensitive layer.

### (Coating solution 1 for protective layer)

| | |
|---|---|
| Polyvinyl alcohol (GL-05, produced by Nippon Synthetic Chemical Industry Co., Ltd.) | 79 parts by weight |
| Polyvinyl pyrrolidone (PVP K-30, produced by ISP Japan Ltd.) | 10 parts by weight |
| Polyethylene imine (LUPAZOL WF, produced by BASF) | 5 parts by weight |
| Cation-modified polyvinyl alcohol (KURARAY C Polymer, produced by Kuraray Co., Ltd.) | 5 parts by weight |
| Surfactant (SURFINOL 465, produced by Nissan Chemical Industries, Ltd.) | 0.5 parts by weight |
| Water | 900 parts by weight |

Lithographic printing plate precursors (2) and (3) were prepared in the same manner as in Lithographic printing plate precursor (1) except for changing the polyvinyl alcohol and cation-modified polyvinyl alcohol in Coating solution 1 for protective layer to Polymer A shown in Table 1, respectively.

### (Evaluation)

Image exposure was conducted at resolution of 2,400 dpi using a plate setter (produced by ECRM Co., Ltd.) equipped with a light source of 405 nm while changing an exposing energy on the surface of lithographic printing plate precursor by 5µJ/cm² in a range from 5 to 50 µJ/cm². After the image exposure, the lithographic printing plate precursor was treated for 30 seconds in a constant temperature reservoir so as to make surface temperature of the lithographic printing plate precursor at 120°C. Then, the lithographic printing plate precursor was processed by a CTP automatic development machine (RAPTOR 85 POLYMER, produced by Glunz & Jensen Co.) provided with a pre-water washing unit for removing a protective layer before development, a developing unit fed with Developer (1) having the composition shown below, a water washing unit for removing the developer attached to the surface of the lithographic printing plate precursor and a gum solution treatment unit fed with gum solution (prepared by diluting twice GW-3, produced by Mitsubishi Chemical Corp.) for protecting the image area, followed by drying.

### (Composition of Developer (1))

| | |
|---|---|
| Potassium silicate | 8.0% by weight |
| NEWCOL B-13SN (produced by Nippon Nyukazai Co., Ltd.) | 2.0% by weight |
| PRONON #204 (produced by NOF Corp.) | 1.0% by weight |
| Potassium hydroxide | Amount to make pH 12.9 |

In Developer (1), the total amount of water and potassium hydroxide was 89.0% by weight and the amount of potassium hydroxide was controlled so as to make pH of Developer (1) 12.9.

Using the lithographic printing plate precursor prepared as described above, sensitivity, printing durability and processing property were evaluated in the manner described below. The results obtained are shown in Table 1.

### <Sensitivity>

Cyan density of the image area of the lithographic printing plate obtained after the development was measured by a Macbeth densitometer. The exposure energy (µJ/cm²) at which the cyan density in the image area became 95% or more of cyan density of the lithographic printing plate precursor before the development was determined to evaluate the sensitivity.

### <Printing durability>

Using the lithographic printing plate obtained after the development, printing was conducted under the conditions described below and a number of printed materials obtained until the ink density (reflection density) on printing paper (SHIRAOI, high-quality paper, produced by Nippon Paper Industries Co., Ltd.) decreased by 0.1 from that at the initiation of printing was determined to evaluate the printing durability. It can be said that the image strength is higher, as the printing durability is higher.

### (Printing conditions)

The lithographic printing plate obtained after the development was mounted on a printing machine (SOR-M, produced by Heidelberg) and printing was conducted at a printing speed of 6,000 sheets per hour using dampening water (EU-3 (etching solution, produced by FUJIFILM Corp.))/water/isopropyl alcohol = 1/89/10 (by volume ratio)) and SPACE COLOR FUSION-G (N) Black Ink (produced by DIC Graphics Corp).

### <Processing property>

After the development processing of 2,000 m² of each lithographic printing plate precursor under the development conditions described above, the generation of scum adhered on the tank wall of the pre-water washing unit for removing a protective layer was observed and evaluated according to the criteria described below.
A: The generation of scum was not observed.
B: The generation of scum was observed, but it was in an acceptable level.
C: The generation of scum was severe.

**TABLE 1**

| | Lithographic Printing Plate Precursor | Polymer A | Sensitivity | Printing Durability | Processing Property |
|---|---|---|---|---|---|
| Comparative Example 1 | (1) | - | 50 | 1.8 × 10⁴ | C |
| Example 1 | (2) | A-1 | 20 | 3.0 × 10⁴ | A |
| Example 2 | (3) | A-6 | 30 | 2.5 × 10⁴ | A |

As is apparent from the results shown in Table 1, the lithographic printing plate precursor using the coating composition according to the invention in the protective layer is excellent in the sensitivity and the printing durability of a lithographic printing plate prepared from the lithographic printing plate precursor and exhibits high processing property in comparison with the lithographic printing plate precursor having the conventional protective layer using polyvinyl alcohol and cation-modified polyvinyl alcohol.

### Examples 3 to 5 and Comparative Examples 2 and 3

### [Preparation of Support]

An aluminum plate of 1S material having a thickness of 0.30 mm was subjected to surface graining using a nylon brush of No.8 and an aqueous suspension containing pumice stone of 800 mesh and then thoroughly washed with water. The plate was immersed in an aqueous 10% by weight sodium hydroxide solution at 70°C for 60 seconds to conduct etching, washed with running water, then washed with an aqueous 20% by weight nitric acid solution for neutralization, and washing with water. The plate was then subjected to the electrolytic surface roughening treatment in an aqueous 1% by weight nitric acid solution using an alternating waveform current of sine wave under the condition of VA = 12.7 V at an anodic time electricity of 300 C/dm². The surface roughness of the plate was measured and found to be 0.45 µm (in terms of Ra). Subsequently, the plate was immersed in an aqueous 30% by weight sulfuric acid solution at 55°C for 2 minutes to conduct desmutting. Then, the plate was anodized in an aqueous 20% by weight sulfuric acid solution at 33°C at a current density of 5 A/dm² for 50 seconds with disposing a cathode on the grained surface of the plate to form an anodic oxide film having a thickness of 2.6 g/m². The plate was referred to as Support 1.

### [Formation of Undercoat layer]

An undercoat solution shown below was coated on Support 1 using a bar coater so as to have a dry coating amount of 2 mg/m² and dried at 80°C for 20 seconds.

### (Undercoat solution)

| | |
|---|---|
| Polymer (P1) shown below (Mw: 100,000) | 0.3 g |
| Pure water | 60.0 g |
| Methanol | 93 9.7 g |

Polymer (P1):

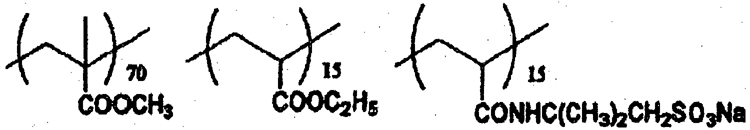

### [Formation of Photosensitive layer]

Coating solution 2 for photosensitive layer having the composition shown below was coated on the support having the undercoat layer described above using a wire bar. Drying was conducted in a hot air drying apparatus at 122°C for 43.5 seconds to form a photosensitive layer. The coverage of the photosensitive layer after drying was 1.4 g/m².

### <Coating solution (2) for photosensitive layer>

| | |
|---|---|
| Infrared absorbing agent (IR-1) | 0.08 g |
| Photo initiator (OS-1) | 0.25 g |
| Radical polymerizable compound | 1.00g |
| Dipentaerythritol hexaacrylate | |
| Binder polymer (BT-1) (Mw: 80,000) | 1.00 g |
| Chloride salt of ethyl violet | 0.04 g |
| Fluorine-based surfactant | 0.03 g |
| (MEGAFAC F-780-F, produced by DIC Corp.) | |
| Methyl ethyl ketone | 10.4 g |
| Methanol | 4.83 g |
| 1-Methoxy-2-propanol | 10.4 g |

The structure of Infrared absorbing agent (IR-1), Photo initiator (OS-1) and Binder polymer (BT-1) used in the coating solution for photosensitive layer described above are shown below. Infrared absorbing agent (IR-1): 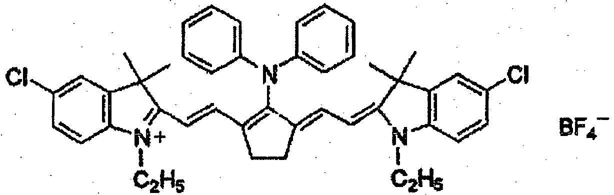 Photo initiator (OS-1): 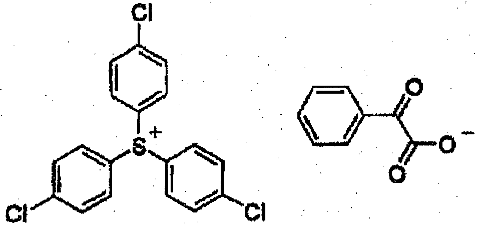 Binder polymer (BT-1):

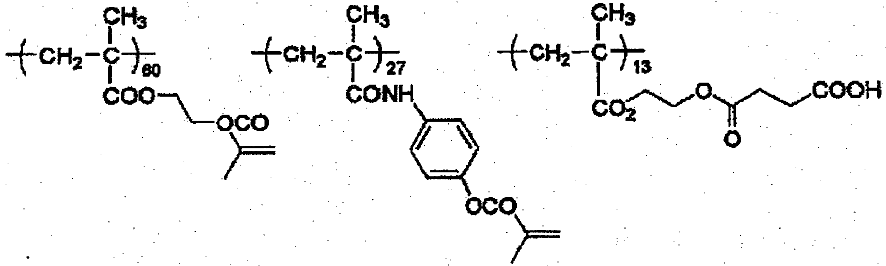

### [Formation of Protective layer]

Coating solution 2 for protective layer shown below was coated on the photosensitive layer by a bar coater so as to have a dry coating weight of 2.5 g/m² and dried at 120°C for one minute to prepare Lithographic printing plate precursor (4).

### (Coating solution 2 for protective layer)

| | |
|---|---|
| Carboxylic acid-modified PVA (KL-118, produced by Kuraray Co., Ltd.) | 5.0 parts by weight |
| Nonionic surfactant (EMALEX 710, produced by Nihon Emulsion Co., Ltd.) | 0.09 parts by weight |
| Pure water | 94.91 parts by weight |

Lithographic printing plate precursor (5) was prepared in the same manner as in Lithographic printing plate precursor (4) except for using highly saponified polyvinyl alcohol (PVA-105, produced by Kuraray Co., Ltd.) in place of KL-118 used in the protective layer.

Lithographic printing plate precursors (6) to (8) were prepared in the same manner as in Lithographic printing plate precursor (4) except for using Polymer A shown in Table 2 in place of KL-118 used in the protective layer, respectively.

### [Evaluation]

The lithographic printing plate precursor obtained was subjected to drawing of an image area ratio of 22% by Trendsetter 3244VX (produced by Creo Co.) equipped with a water-cooled 40 W infrared semiconductor laser at a rotational number of an external drum of 150 rpm and resolution of 2,438 dpi. After the exposure, the exposed lithographic printing plate precursor was developed at 30°C for 12 seconds using an automatic developing machine (LP-1310HII, produced by FUJIFILM Corp.) with a solution (pH = 12.1) prepared by diluting Developer DH-N (produced by FUJIFILM Corp.) five times with water. The finisher used was a solution prepared by diluting FP-2W (produced by FUJIFILM Corp.) with water in a ratio of 1:1.

### (Evaluation of processing property)

The lithographic printing plate precursor having a size of 1030 x 800 mm was processed at a rate of 100 plates per day for 60 days, and after 1 day, 15 days, 30 days and 60 days of the processing, the developer was removed from a developing bath tank and a state of precipitation in the developing bath tank was observed. A case where the precipitate became deposited was evaluated as C and a case where the precipitate did not become deposited was evaluated as A.

### (Evaluation of adhesion of scum of polymer for protective layer on plate)

The lithographic printing plate precursor having a size of 1030 x 800 mm was processed at a rate of 100 plates per day for 60 days, and after 1 day, 15 days, 30 days and 60 days of the processing, a number of the scum of polymer (gelled material) for protective layer adhered on the plate was counted with respect to the 50 plates processed to calculate an average adhesion number per plate.

### (Evaluation of printing durability)

Using the lithographic printing plate obtained after the development, the printing durability was evaluated in the same manner as in Example 1.

**TABLE 2**

| | Lithographic Printing Plate Precursor | Polymer A | Processing Property | | | | Adhesion of Scum | | | | Printing Durability |
|---|---|---|---|---|---|---|---|---|---|---|---|
| | | | 1 Day | 15 Days | 30 Days | 60 Days | 1 Day | 15 Days | 30 Days | 60 Days | |
| Comparative Example 2 | (4) | - | A | A | A | C | 0 | 0 | 0 | 2 | 1.0 × 10⁴ |
| Comparative Example 3 | (5) | - | A | C | C | C | 0 | 8 | 8 | 20 | 1.4 × 10⁴ |
| Example 3 | (6) | A-2 | A | A | A | A | 0 | 0 | 0 | 0 | 2.0 × 10⁴ |
| Example 4 | (7) | A-3 | A | A | A | A | 0 | 0 | 0 | 0 | 1.8 × 10⁴ |
| Example 5 | (8) | A-4 | A | A | A | A | 0 | 0 | 0 | 0 | 1.6 × 10⁴ |

As is apparent from the results shown in Table 2, the lithographic printing plate precursor using the coating composition according to the invention in the protective layer has high processing property and is excellent in the printing durability of a lithographic printing plate prepared from the lithographic printing plate precursor in comparison with the lithographic printing plate precursor having the conventional protective layer using polyvinyl alcohol or carboxylic acid-modified polyvinyl alcohol.

### Examples 6 and 7 and Comparative Example 4

### [Preparation of Support]

A melt of JIS A 1050 alloy containing not less than 99.5% by weight of aluminum, 0.30% by weight of Fe, 0.10% by weight of Si, 0.02% by weight of Ti and 0.013% by weight of Cu was subjected to a cleaning treatment and casting. The cleaning treatment includes a degassing treatment for removing undesirable gas, for example, hydrogen gas in the melt and a treatment with a ceramic tube filter. The casting was conducted according to a DC casting method.

A surface of the solidified ingot plate having a plate thickness of 500 mm was ground by 10 mm, and the ingot plate was subjected to a homogenizing treatment at 550°C for 10 hours in order to prevent the formation of coarse intermetallic compound.

Then, the ingot plate was subjected to hot rolling at 400°C, intermediate annealing in a continuous annealing furnace at 500°C for 60 seconds, and cold rolling to produce a rolled aluminum plate having a thickness of 0.30 mm. The center line average surface roughness Ra of the rolled aluminum plate was adjusted to 0.2 µm by means of controlling the roughness of rolling roller. Thereafter, the aluminum plate was subjected to treatment with a tension leveler for improving the flatness thereof.

The aluminum plate was then subjected to surface treatment for preparing a support for lithographic printing plate precursor in the following manner.

First, the aluminum plate was subjected to a degreasing treatment with an aqueous 10% by weight sodium alminate solution at 50°C for 30 seconds for removing rolling oil on the surface thereof and then neutralization and desmut treatments with an aqueous 30% by weight sulfuric acid solution at 50°C for 30 seconds.

Then, a so-called graining treatment for roughening a surface of the support was carried out for improving an adhesion property between the support and the photosensitive layer and also imparting a water-retaining property to the non-image area. Specifically, the aluminum web was transported in an aqueous solution containing 1% by weight of nitric acid and 0.5% by weight of aluminum nitrate, which had been maintained at 45°C, while applying an anode side quantity of electricity of 240C/dm² at a current density of 20 A/dm² and an alternating waveform of a duty ratio of 1 : 1 by means of an indirect electric power supply cell, whereby electrolytic graining was conducted. The aluminum web was then subjected to an etching treatment with an aqueous 10% by weight sodium alminate solution at 50°C for 30 seconds, and neutralization and desmut treatments with an aqueous 30% by weight sulfuric acid solution at 50°C for 30 seconds.

For the purpose of further improving abrasion resistance, chemical resistance and water-retaining property, an oxide film was formed on the surface of support by an anodizing treatment. Specifically, the aluminum web was transported in an aqueous 20% by weight sulfuric acid solution as an electrolyte at 35°C to carry out an electrolytic treatment with a direct current of 14 A/dm² by means of an indirect electric power supply cell, whereby an anodized film of 2.5 g/m² was formed.

### [Formation of Undercoat layer]

An undercoat solution shown below was coated on the aluminum support described above by a wire bar and dried using a hot air drying apparatus at 90°C for 30 seconds. The coverage of the undercoat layer after drying was 10 mg/m².

### (Undercoat solution)

| | |
|---|---|
| Copolymer of ethyl acrylate and sodium 2-acrylamido-2-methyl-1-propanesulfonaxe (75 : 15 by molar ratio) (Mw: 70,000) | 0.1 g |
| 2-Aminoethylphosphonic acid | 0.1 g |
| Methanol | 50 g |
| Ion-exchanged water | 50 g |

### [Formation of Photosensitive layer]

Coating solution 3 for photosensitive layer having the composition shown below was prepared, coated on the aluminum support having the undercoat layer described above using a wire bar and dried by a hot air drying apparatus at 115°C for 45 seconds to form a photosensitive layer. The coverage of the photosensitive layer after drying was 1.25 g/m².

### <Coating solution (3) for photosensitive layer>

| | |
|---|---|
| Infrared absorbing agent (IR-2) | 0.08 g |
| Photo initiator (S-1) | 0.30 g |
| Radical polymerizable compound (M-1) | 1.00 g |
| Binder polymer (B-1) | 1.20 g |
| Chloride salt of ethyl violet | 0.04 g |
| Fluorine-based surfactant | 0.02 g |
| (MEGAFAC F-176, produced by DIC Corp.) | |
| Methyl ethyl ketone | 9.0 g |
| Methanol | 8.0 g |
| 1-Methoxy-2-propanol | 8.0 g |

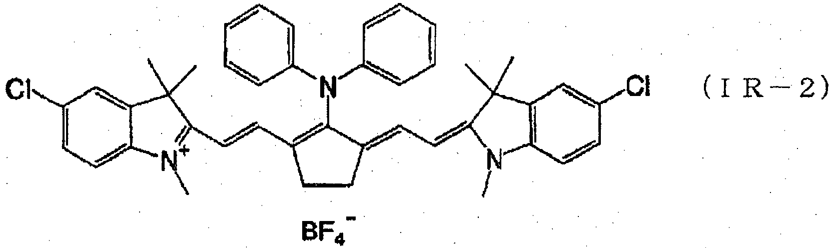

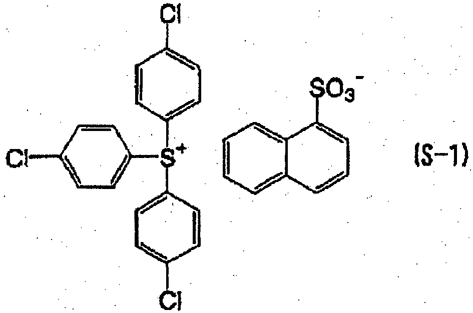

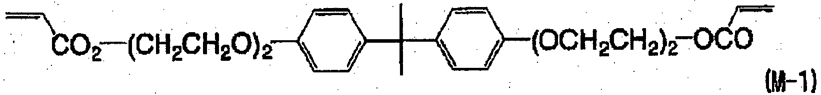

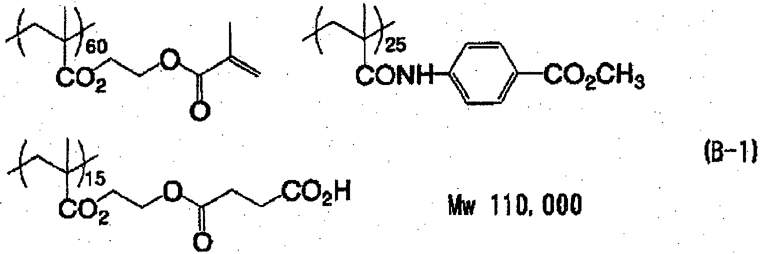

### [Formation of Protective layer]

Coating solution 3 for protective layer having the composition shown below was coated on the photosensitive layer described above using a slide hopper and dried by a hot air drying apparatus at 120°C for 75 seconds to prepare Lithographic printing plate precursor (9). The coating amount of the protective layer was 2.1 g/m².

### (Coating solution 3 for protective layer)

| | |
|---|---|
| Resin for protective layer C-1 | 2.0 g (solid content) |
| Nonionic surfactant (EMALEX NP-10, produced by Nihon Emulsion Co., Ltd.) | 0.03 g |
| Ion-exchanged water | 96.9 g |

Resin for protective layer C-1 (each number attached to each unit indicates a polymerization degree):

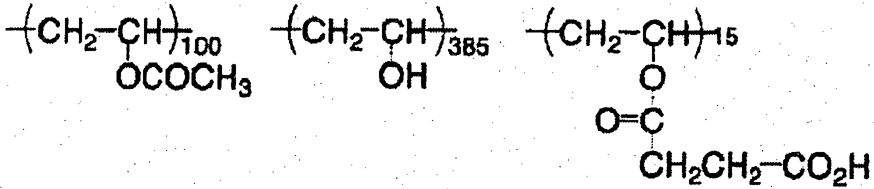

Lithographic printing plate precursors (10) and (11) were prepared in the same manner as in Lithographic printing plate precursor (9) except for changing Resin for protective layer C-1 to Polymer A shown in Table 3, respectively.

### [Evaluation of sensitivity]

The lithographic printing plate precursor obtained was exposed by Trendsetter 3244VX (produced by Creo Co.) equipped with a water-cooled 40 W infrared semiconductor laser at resolution of 175 lpi and a rotational number of an external drum of 150 rpm while changing output by 0.15 in log E in a range from 0 to 8 W.

After the exposure, the protective layer was removed by water washing with tap water and the exposed lithographic printing plate precursor was subjected to development using an automatic developing machine (LP-1310HII, produced by FUJIFILM Corp.) at 30°C for 12 seconds. The developer used was a solution (pH = 12.0) prepared by diluting DV-2(produced by FUJIFILM Corp.) with water in a ratio of 1:4. The finisher used was a solution prepared by diluting FP-2W (produced by FUJIFILM Corp.) with water in a ratio of 1:1.

Based on the line width of the image obtained by the exposure and development, laser output, loss in the optical system and scanning speed, the amount of energy (mJ/cm²) required for recording was calculated. A smaller numerical value indicates higher sensitivity. The results obtained are shown in Table 3.

### [Evaluation of development scum]

A total of 2,000 m² of the lithographic printing plate precursor in the unexposed state was subjected to development processing using an automatic developing machine (IP85HD, produced by G&J), at a line speed (transporting speed) of 1.5 m/min without operating its heating unit. In the development processing, a solution prepared by diluting DV-2(produced by FUJIFILM Corp.) with water in a ratio of 1:4 was used as the developer for tank solution and replenisher. Then, stain in the developer tank was visually observed. The evaluation was conducted according to a five-grade sensory evaluation of 1 to 5 wherein 1 was a level in that stain was severe and 5 was a level in that that stain was not observed at all. In the grade, 2 or less is unable to practically use and 3 is a lower limit for practical use. The results obtained are shown in Table 3.

### [Evaluation of printing durability]

The lithographic printing plate obtained by the processing same as in the evaluation of sensitivity (exposure energy being 40 mJ/cm²) was subjected to printing by a printing machine (R201, produced by Roland Co.) using dampening water (EU-3 (etching solution, produced by FUJIFILM Corp.))/water/isopropyl alcohol = 1/89/10 (by volume ratio)), SPACE COLOR FUSION-G (N) Black Ink (produced by DIC Graphics Corp) and printing paper (SHIRAOI, high-quality paper, produced by Nippon Paper Industries Co., Ltd.). The solid image area of the printed material was observed and the printing durability was examined by a number of prints when the image started to become thin. The printing durability is more excellent, as the number of sheets is larger. The results obtained are shown in Table 3.

### [Evaluation of development property]

The lithographic printing plate precursor obtained was exposed by Trendsetter 3244VX (produced by Creo Co.) equipped with a water-cooled 40 W infrared semiconductor laser at output of 9 W, a rotational number of an external drum of 210 rpm, plate surface energy of 100 mJ/cm² and resolution of 2,400 dpi.

After the exposure, the exposed lithographic printing plate precursor was subjected to development processing using an automatic developing machine (STABLON 900N, produced by FUJIFILM Corp.). The developer used was a solution prepared by diluting DV-2(produced by FUJIFILM Corp.) with water in a ratio of 1:4. The temperature of the developing bath was 30°C. The finisher used was a solution (pH = 10.8) prepared by diluting FN-6 (produced by FUJIFILM Corp.) with water in a ratio of 1:1.

The development was conducted under the development conditions as described above except for only changing the transporting speed of the automatic developing machine and an immersion time in the developer required for completely removing the unexposed area of the lithographic printing plate precursor was determined. A smaller numerical value indicates more excellent development property. The results obtained are shown in Table 3.

**TABLE 3**

| | Lithographic Printing Plate Precursor | Polymer A | Sensitivity | Development Scum | Printing Durability | Development property |
|---|---|---|---|---|---|---|
| Comparative Example 4 | (9) | - | 65 | 2 | 7.0 × 10⁴ | 10 sec |
| Example 6 | (10) | A-5 | 55 | 5 | 8.0 × 10⁴ | 5 sec |
| Example 7 | (11) | A-7 | 55 | 4 | 8.0 × 10⁴ | 7 sec |

As is apparent from the results shown in Table 3, the lithographic printing plate precursor using the coating composition according to the invention in the protective layer is excellent in the printing durability and sensitivity and exhibits high processing property and development property in comparison with the lithographic printing plate precursor having the conventional protective layer using carboxylic acid-modified polyvinyl alcohol.

### Examples 8 to 11

### [Preparation of Support]

An aluminum plate (material: JIS A 1050) having a thickness of 0.3 mm was subjected to a degreasing treatment at 50°C for 30 seconds using an aqueous 10% by weight sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by immersing in an aqueous 25% by weight sodium hydroxide solution of 45°C for 9 seconds, washed with water, then immersed in an aqueous 20% by weight nitric acid solution at 60°C for 20 seconds, and washed with water. The etching amount of the grained surface was about 3 g/m².

Then, using an alternating current of 60 Hz, an electrochemical roughening treatment was continuously carried out on the aluminum plate. The electrolytic solution used was an aqueous 1 % by weight nitric acid solution (containing 0.5% by weight of aluminum ion) and the temperature of electrolytic solution was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current and 5% of the electric current flowing from the current source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, an aqueous 0.5% by weight hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying. The plate was subjected to an anodizing treatment using as an electrolytic solution, an aqueous 15% by weight sulfuric acid solution (containing 0.5% by weight of aluminum ion) at a current density of 15 A/dm² to form a direct current anodized film of 2.5 g/m², washed with water and dried.

The center line average roughness (Ra) of the support thus obtained was measured using a stylus having a diameter of 2 µm and found to be 0.51 µm.

### [Formation of Undercoat layer]

Undercoat solution shown below was coated on the support by a bar and dried in an oven at 80°C for 10 seconds to prepare a support having an undercoat layer having a dry coating amount of 10 mg/m² for using in the experiments described below.

### (Undercoat solution)

| | |
|---|---|
| Undercoat compound (1) shown below (Mw: 100,000) | 0.017 g |
| Methanol | 9.00 g |
| Water | 1.00 g |

### Undercoat compound (1) (Mw: 100,000):

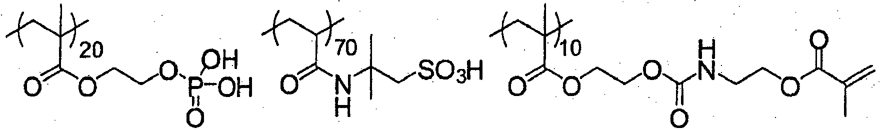

### [Formation of Photosensitive layer]

Coating solution 4 for photosensitive layer having the composition shown below was coated on the support having the undercoat layer described above by a bar and dried in an oven at 70°C for 60 seconds to form a photosensitive layer having a dry coating amount of 1.1 g/m².

### (Coating solution 4 for photosensitive layer)

| | |
|---|---|
| Binder polymer (1) shown below (Mw: 100,000) | 0.54 g |
| Radical polymerizable compound (2) shown below | 0.48 g |
| (PLEX 6661-O, produced by Degussa Japan Co., Ltd.) | |
| Sensitizing dye (1) shown below | 0.06 g |
| Photo initiator (1) shown below | 0.18 g |
| Chain transfer agent (1) shown below | 0.07 g |
| Dispersion of ε-phthalocyanine pigment (1) | 0.40 g |
| [pigment: 15 parts by weight; dispersing agent (allyl methacrylate/methacrylic acid (80/20 in molar ratio) copolymer, Mw: 80,000): 10 parts by weight; solvent (cyclohexanone/methoxypropyl acetate/ 1-methoxy-2-propanol =15 parts by weight/20 parts by weight/40 parts by weight)] | |
| Thermal polymerization inhibitor | 0.01 g |
| N-Nitrosophenylhydroxylamine aluminum salt | |
| Water-soluble fluorine-based surfactant (1) shown below (Mw: 13,000) | 0.001 g |
| Polyoxyethylene-polyoxypropylene condensate | 0.04 g |
| (PLURONIC L44, produced by ADEKA Corp.) | |
| 1-Methoxy-2-propanol | 3.5 g |
| Methyl ethyl ketone | 8.0 g |

Radical polymerizable compound (2): 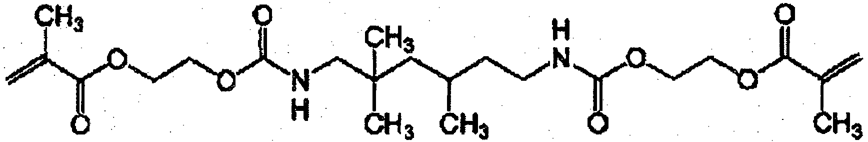 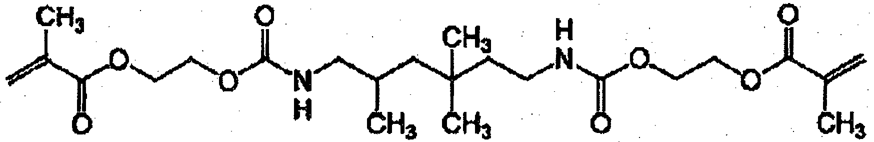 (Mixture of the isomers described above)
Sensitizing dye (1): 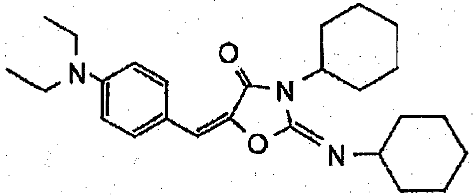 Photo initiator (1): 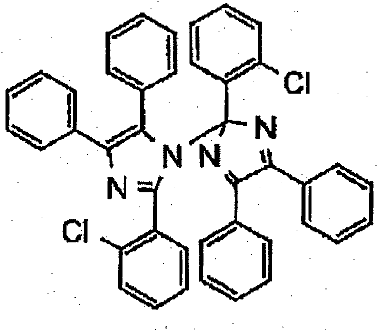 Chain transfer agent (1): 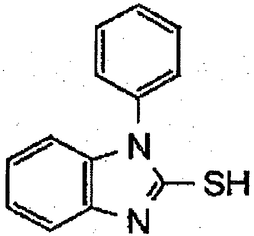 Binder polymer (1): 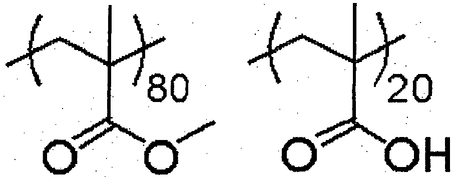 Water-soluble fluorine-based surfactant (1):

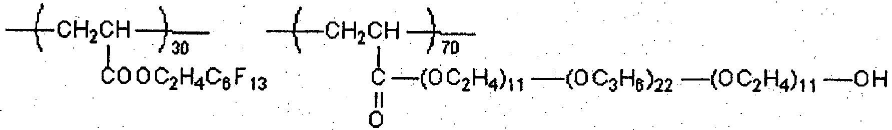

### [Formation of Protective layer]

Coating solution 4 for protective layer having the composition shown below was coated on the photosensitive layer using a bar so as to have a dry coating amount of 0.75 g/m² and dried at 125°C for 70 seconds to form Lithographic printing plate precursors (12) to (15), respectively.

### (Coating solution 4 for protective layer)

| | |
|---|---|
| Dispersion of inorganic stratiform compound (1) shown below | 13.0 g |
| Polymer A shown in Table 4 | 1.3 g |
| Sodium 2-ethylhexylsulfosuccinate | 0.2 g |
| Vinyl pyrrolidone/vinyl acetate (1/1) copolymer (Mw: 70,000) | 0.05 g |
| Surfactant (EMALEX 710, produced by Nihon Emulsion Co., Ltd.) | 0.05 g |
| Water | 133 g |

### (Preparation of Dispersion of inorganic stratiform compound (1))

To 368 g of water was added 32 g of synthetic mica (SOMASIF ME-100, produced by CO-OP Chemical Co., Ltd., aspect ratio: 1,000 or more) and the mixture was dispersed using a homogenizer until an average particle size (according to a laser scattering method) became 0.5 µm to prepare Dispersion of inorganic stratiform compound (1).

### [Conditions of Exposure and Development]

### (1) Condition of preparing standard lithographic printing plate

Each of Lithographic printing plate precursors (12) to (15) was subjected to imagewise exposure using a semiconductor laser of 405 nm having output of 100 mW in an exposure amount of 300µJ/cm².

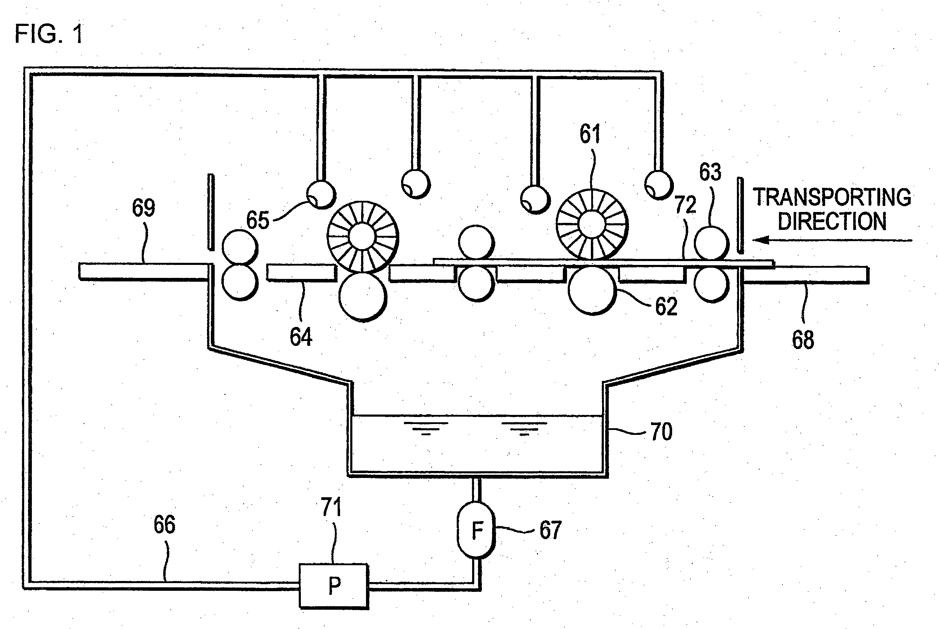

Then, the exposed lithographic printing plate precursor was subjected to development processing in Automatic development processor A having a structure shown in Fig. 1 using Developer (2) having the composition shown below. The automatic development processor was an automatic processor having two rotating brush rollers. The first brush roller was a brush roller having an outer diameter of 90 mm and being implanted with fiber of polybutylene terephthalate (bristle diameter: 200 µm, bristle length: 17 mm), and the brush roller was rotated at 200 rpm (peripheral velocity at the tip of brush: 0.94 m/sec) in the same direction as the transporting direction of the lithographic printing plate precursor. The second brush roller was a brush roller having an outer diameter of 60 mm and being implanted with fiber of polybutylene terephthalate (bristle diameter: 200µm, bristle length: 17 mm), and the brush roller was rotated at 200 rpm (peripheral velocity at the tip of brush: 0.63 m/sec) in the opposite direction to the transporting direction of the lithographic printing plate precursor. The transportation of the lithographic printing plate precursor was conducted at a transporting speed of 100 cm/min.

The developer was supplied on the surface of the lithographic printing plate precursor by showering from a spray pipe using a circulation pump. The tank volume for the developer was 10 liters. Thus, Standard lithographic printing plates (12) to (15) were prepared.

### (2) Condition of preparing pre-heated lithographic printing plate

Each of Lithographic printing plate precursors (12) to (15) was subjected to imagewise exposure using a semiconductor laser of 405 nm having output of 100 mW in an exposure amount of 90 µJ/cm². Within 30 seconds after the exposure, the exposed lithographic printing plate precursor was put in an oven, heated the entire surface of the lithographic printing plate precursor by blowing hot air to maintain at 110°C for 15 seconds and then, within 30 seconds, the lithographic printing plate precursor was subjected to the development processing in the same manner as in Condition of preparing standard lithographic printing plate to prepare Pre-heated lithographic printing plates (12) to (15), respectively.

### (3) Condition ofpreparing lithographic printing plate for evaluating sensitivity

Each of Lithographic printing plate precursors (12) to (15) was subjected to imagewise exposure using a semiconductor laser of 405 nm having output of 100 mW while changing the exposure amount. Then, the exposed lithographic printing plate precursor was subjected to the development processing in the same manner as in Condition of preparing standard lithographic printing plate to prepare Lithographic printing plates (12) to (15) for evaluating sensitivity, respectively.

### (4) Condition of preparing lithographic printing plate for evaluating development property

Each of Lithographic printing plate precursors (12) to (15) was subjected to the imagewise exposure in the same manner as in Condition of preparing standard lithographic printing plate and then subjected to the development processing in the same manner as in Condition of preparing standard lithographic printing plate except for variously changing the transporting speed of the lithographic printing plate precursor to prepare Lithographic printing plates (12) to (15) for evaluating development property, respectively.

### (Composition of Developer (2))

| | |
|---|---|
| Water | 100.00 g |
| Benzyl alcohol | 1.00 g |
| Polyoxyethylene naphthyl ether (average number of oxyethylene: n =13) | 1.00 g |
| Sodium salt of dioctylsulfosuccinate | 0.50 g |
| Gum arabic | 1.00 g |
| Ethylene glycol | 0.50 g |
| Ammonium primary phosphate | 0.05 g |
| Citric acid | 0.05 g |
| Sodium carbonate | 1.40 g |
| Sodium hydrogen carbonate | 0.59 g |

(pH of the developer was adjusted to 9.8 using phosphoric acid and sodium hydroxide)

### [Condition of printing]

The lithographic printing plate thus-obtained after the development was mounted on a printing machine (SOR-M, produced by Heidelberg), and printing was conducted at a printing speed of 6,000 sheets per hour using dampening water (EU-3 (etching solution, produced by FUJIFILM Corp.))/water/isopropyl alcohol = 1/89/10 (by volume ratio)), SPACE COLOR FUSION-G (N) Black Ink (produced by DIC Graphics Corp.) and printing paper (SHIRAOI, high-quality paper, produced by Nippon Paper Industries Co., Ltd.).

### [Evaluation]

Using the lithographic printing plate precursor prepared above, sensitivity, development property, stain resistance and printing durability were evaluated in the manner described below. The results obtained are shown in Table 4.

### <Sensitivity>

Using the lithographic printing plate for evaluating sensitivity, after performing printing of 100 sheets as described above and confirming that a printed material free from ink stain in the non-image area was obtained, 500 sheets were continuously printed. The exposure amount (µJ/cm²) for causing no unevenness in the ink density of the image area on the 600th printed material was determined to evaluate the sensitivity.

### <Printing durability>

The printing was performed as described above using the standard lithographic printing plate and pre-heated lithographic printing plate and a number of printed materials obtained until the ink density (reflection density) on the printing paper decreased by 0.1 from that at the initiation of printing was determined to evaluate the printing durability.

### <Development property>

Using the lithographic printing plate for evaluating development property, cyan density of the non-image area was measured by a Macbeth densitometer. The transporting speed (cm/min) at which the cyan density of the non-image area became equivalent to cyan density of the aluminum support was determined to evaluate the development property.

### <Processing property>

After the development processing of 2,000 m² of each lithographic printing plate precursor by the automatic development processor under the condition of preparing standard lithographic printing plate described above, the generation of scum adhered on the tank wall of the automatic development processor was observed and evaluated according to the criteria described below.
A: The generation of scum was not observed.
B: The generation of scum was observed, but it was in an acceptable level.
C: The generation of scum was severe.

### <Stain resistance>

Using the standard lithographic printing plate and pre-heated lithographic printing plate, after performing the printing of 500 sheets as described above, ink stain generated in the non-image area was visually observed. On the 500th printed material, a case where the non-image area did not stained at all was taken as 10 and a case where due to adhesion of ink the non-image area was almost stained was taken as 1.

**TABLE 4**

| | Lithographic Printing Plate Precursor | Polymer A | Sensitivity | Printing Durability | | Development Property | Processing Property | Stain Resistance | |
|---|---|---|---|---|---|---|---|---|---|
| | | | | Standard | Pre-heated | | | Standard | Pre-heated |
| Example 8 | (12) | A-1 | 250 | 5.0 × 10⁴ | 10.0 × 10⁴ | 130 | A | 10 | 10 |
| Example 9 | (13) | A-2 | 260 | 4.8 × 10⁴ | 9.5 × 10⁴ | 120 | A | 10 | 10 |
| Example 10 | (14) | A-3 | 270 | 4.5 × 10⁴ | 9.2 × 10⁴ | 110 | A | 10 | 10 |
| Example 11 | (15) | A-8 | 270 | 4.7 × 10⁴ | 9.4 × 10⁴ | 110 | A | 10 | 10 |

### Examples 12 and 13

### [Preparation of Support]

An aluminum plate (material: JIS A 1050, refining: H16) having a thickness of 0.24 mm was immersed in an aqueous 5% by weight sodium hydroxide solution maintained at 65°C to conduct a degreasing treatment for one minute, followed by washed with water. The degreased aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The surface-roughened and desmuted aluminum plate was subjected to an anodizing treatment under condition of current density of 10 A/dm² and voltage of 15 V in an aqueous 15% by weight sulfuric acid solution at 25°C for one minute and then subjected to a hydrophilizing treatment using an aqueous 1% by weight polyvinylphosphonic acid solution at 75°C to prepare a support. The surface roughness of the support was measured and found to be 0.44 µm (Ra indication according to JIS B 0601).

### [Formation of Photosensitive layer]

Coating solution 5 for photosensitive layer having the composition shown below was coated on the support described above by a bar and dried in an oven at 90°C for 60 seconds to form a photosensitive layer having a dry coating amount of 1.3 g/m².

### (Coating solution 5 for photosensitive layer)

| | |
|---|---|
| Binder polymer (2) (Mw: 80,000) shown below | 0.04 g |
| Binder polymer (3) (Mw: 30,000) shown below | 0.30 g |
| Radical polymerizable compound (2) shown above | 0.17 g |
| Radical polymerizable compound (3) shown below | 0.51 g |
| Sensitizing dye (2) shown below | 0.03 g |
| Sensitizing dye (3) shown below | 0.015 g |
| Sensitizing dye (4) shown below | 0.015 g |
| Photo initiator (1) shown above | 0.09 g |
| Chain transfer agent | 0.008 g |
| Mercaptobenzothiazole | |
| Dispersion of ε-phthalocyanine pigment | 0.40 g |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| Thermal polymerization inhibitor | 0.01 g |
| N-Nitrosophenylhydroxylamine aluminum salt | |
| Water-soluble fluorine-based surfactant (1) shown above | 0.001 g |
| 1-Methoxy-2-propanol | 3.5 g |
| Methyl ethyl ketone | 8.0 g |

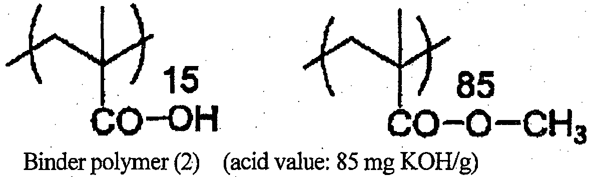

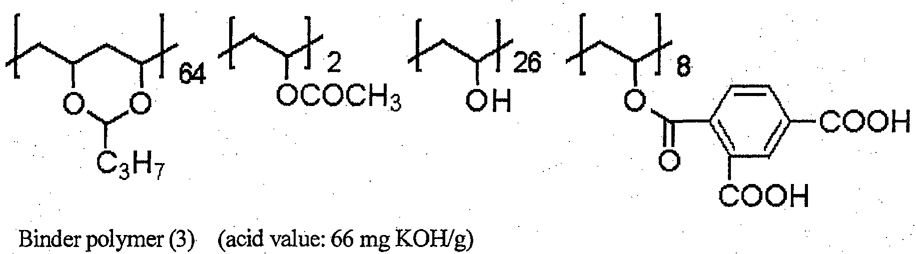

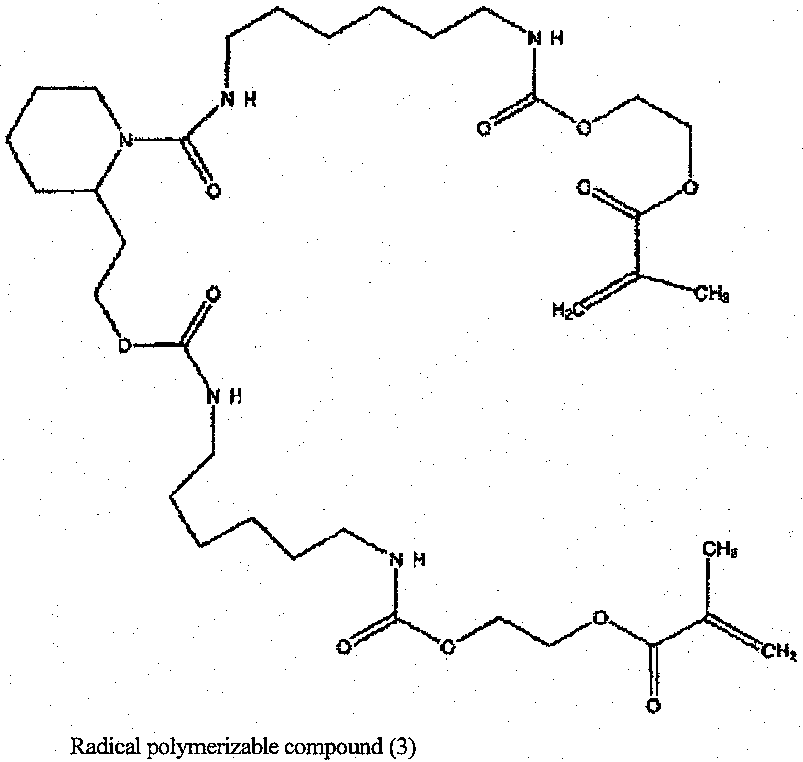

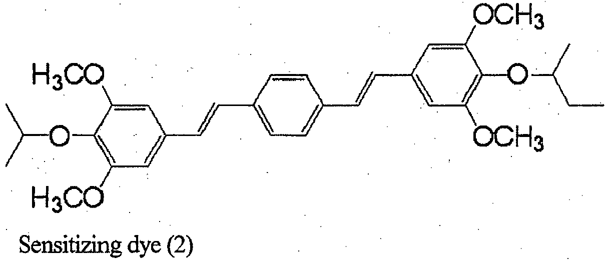

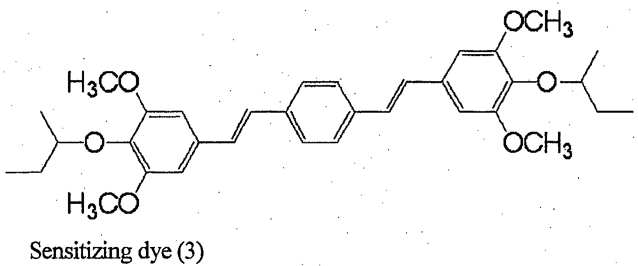

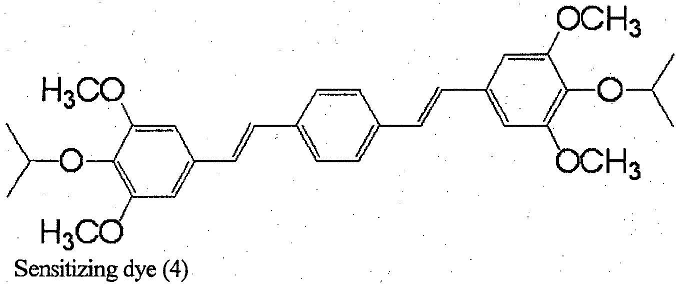

### [Formation of Protective layer]

Coating solution 5 for protective layer having the composition shown below was coated on the photosensitive layer described above using a bar so as to have a dry coating amount of 1.2 g/m² and dried at 125°C for 70 seconds to form a protective layer, thereby preparing Lithographic printing plate precursors (16) and (17).

### (Coating solution 5 for protective layer)

| | |
|---|---|
| Polymer A shown in Table 5 | 0.800 g |
| Vinyl pyrrolidone/vinyl acetate (1/1 by molar ratio) copolymer (Mw: 70,000) | 0.001 g |
| Surfactant (EMALEX 710, produced by Nihon Emulsion Co., Ltd.) | 0.002 g |
| Water | 13 g |

### [Exposure, Development and Printing]

The lithographic printing plate precursor was subjected to image exposure by Violet semiconductor laser plate setter Vx9600 (equipped with InGaN semiconductor laser; emission: 405 nm ± 10 nm/output: 30 mW) produced by FUJIFILM Electronic Imaging, Ltd. The image drawing was conducted at a resolution of 2,438 dpi with halftone dots of 50% using an FM screen (TAFFETA 20, produced by FUJIFILM Corp.) in a plate surface exposure amount of 0.15 mJ/cm².

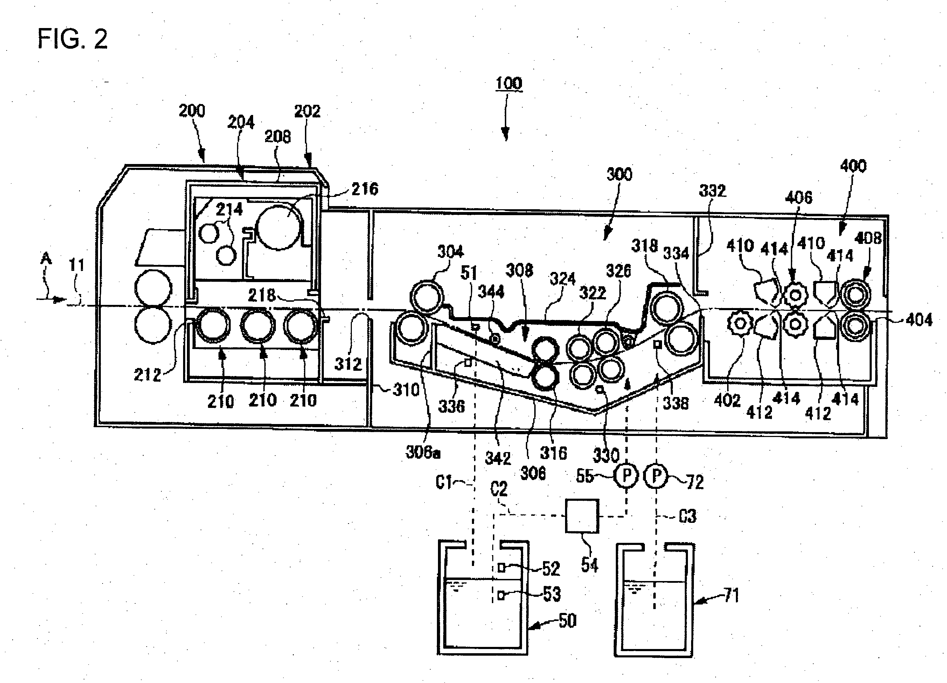

Then, the exposed lithographic printing plate precursor was subjected to development processing by Automatic development processor B having a structure shown in Fig. 2 using Developer (3) having the composition shown below at a transporting speed so as to regulate pre-heating time of 10 seconds at 100°C and immersion time (developing time) in the developer of 20 seconds. Also, for the purpose of evaluating the development property, the development was conducted with variously changing the immersion time.

The lithographic printing plate thus-obtained was mounted on a printing machine (SOR-M, produced by Heidelberg) and printing was conducted at a printing speed of 6,000 sheets per hour using dampening water (EU-3 (etching solution, produced by FUJIFILM Corp.))/water/isopropyl alcohol = 1/89/10 (by volume ratio)), SPACE COLOR FUSION-G (N) Black Ink (produced by DIC Graphics Corp.) and printing paper (SHIRAOI, high-quality paper, produced by Nippon Paper Industries Co., Ltd.).

### <Composition of Developer (3)>

| | |
|---|---|
| Water | 88.6 g |
| Nonionic surfactant (W-1) having structure shown below | 2.4 g |
| Nonionic surfactant (W-2) having structure shown below | 2.4 g |
| Nonionic surfactant (EMALEX 710, produced by Nihon Emulsion Co., Ltd.) | 1.0 g |
| Phenoxypropanol | 1.0 g |
| Octanol | 0.6 g |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |
| Polystyrenesulfonic acid (VERSA TL77 (30% by weight solution) produced by Alco Chemical Inc.) | 1.0 g |

(pH was adjusted to 7.0 by adding phosphoric acid to the developer having the composition described above)

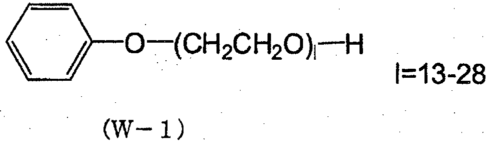

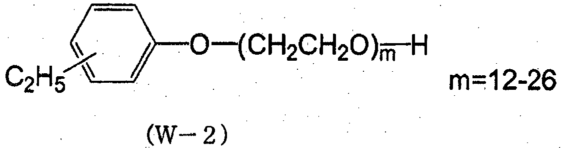

### [Evaluation]

### <Sensitivity>

The development processing and printing were conducted under the same conditions of exposure, development and printing described above except for variously changing the plate surface exposure amount. After performing printing of 100 sheets and confirming that a printed material free from ink stain in the non-image area was obtained, 500 sheets were continuously printed. The exposure amount (µJ/cm²) for causing no unevenness in the ink density of the image area on the 600th printed material was determined to evaluate the sensitivity. The results obtained are shown in Table 5.

### <Development property>

After the development processing described above, the non-image area of the lithographic printing plate obtained was visually observed and the immersion time (sec) in the developer for which the photosensitive layer did not remain to obtain good development property was determined to evaluate the development property. The results obtained are shown in Table 5.

### <Processing property>

After the development processing of 500 m² of each lithographic printing plate precursor by the automatic development processor in the manner as described above, the generation of scum adhered on the tank wall of the automatic development processor was observed and evaluated according to the criteria described below.
A: The generation of scum was not observed.
B: The generation of scum was observed, but it was in an acceptable level.
C: The generation of scum was severe.

The results obtained are shown in Table 5.

### <Printing durability>

As increase in the number of printed materials, the image of the photosensitive layer formed on the lithographic printing plate was gradually abraded to cause decrease in the ink receptivity, resulting in decrease in ink density of the image on a printing paper. A number of printed materials obtained until the ink density (reflection density) decreased by 0.1 from that at the initiation of printing was determined to evaluate the printing durability. The results obtained are shown in Table 5.

### <Stain resistance>

After performing the printing of 500 sheets under the conditions of exposure, development and printing as described above, ink stain generated in the non-image area was visually observed. On the 500th printed material, a case where the non-image area did not stained at all was taken as 10 and a case where due to adhesion of ink the non-image area was almost stained was taken as 1. The results obtained are shown in Table 5.

**TABLE 5**

| | Lithographic Printing Plate Precursor | Polymer A | Sensitivity | Printing Durability | | Development Property | Processing Property | Stain Resistance | |
|---|---|---|---|---|---|---|---|---|---|
| | | | | Standard | Pre-heated | | | Standard | Pre-heated |
| Example 12 | (16) | A-6 | 110 | - | 8.5 × 10⁴ | 10 | A | - | 10 |
| Example 13 | (17) | A-9 | 100 | - | 9.0 × 10⁴ | 12 | A | - | 10 |

### Examples 14 to 17 and Comparative Example 5

### [Preparation of Support]

The support prepared in the manner as described in Examples 8 to 11 was further treated with an aqueous 2.5% by weight sodium silicate solution at 30°C for 10 seconds. The center line average roughness (Ra) of the support was measured using a stylus having a diameter of 2 µm and found to be 0.51 µm.

### [Formation of Undercoat layer]

Undercoat solution shown below was coated on the support subjected to the sodium silicate treatment so as to have a dry coating amount of 10 mg/m².

### (Undercoat solution)

| | |
|---|---|
| Undercoat compound (2) shown below (Mw: 100,000) | 0.017 g |
| Methanol | 9.00 g |
| Water | 1.00 g |

Undercoat compound (2):

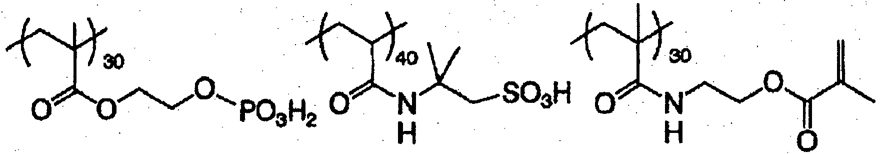

### [Formation of Photosensitive layer]

Coating solution 6 for photosensitive layer having the composition shown below was coated on the support by a bar and dried in an oven at 160°C for 60 seconds to form a photosensitive layer having a dry coating amount of 1.0 g/m². Coating solution 6 for photosensitive layer was prepared by mixing Photosensitive solution (1) shown below and Microcapsule aqueous solution (1) shown below just before the coating, followed by stirring.

### Photosensitive solution (1)

| | |
|---|---|
| Binder polymer (4) shown below | 0.162 g |
| Photo initiator (2) shown below | 0.100 g |
| Infrared absorbing agent (IR-1) shown above | 0.020 g |
| Radical polymerizable compound (ARONIX M-215, produced by Toagosei Co., Ltd.) | 0.385 g |
| Water-soluble fluorine-based surfactant (1) shown above | 0.044 g |
| Naphthalenesulfonate of Victoria Pure Blue | 0.010 g |
| Methyl ethyl ketone | 1.091 g |
| 1-Methoxy-2-propanol | 8.609 g |

Microcapsule aqueous solution (1)

| | |
|---|---|
| Microcapsule (1) prepared as shown below | 2.640 g |
| Water | 2.425 g |

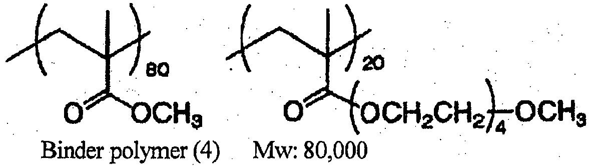

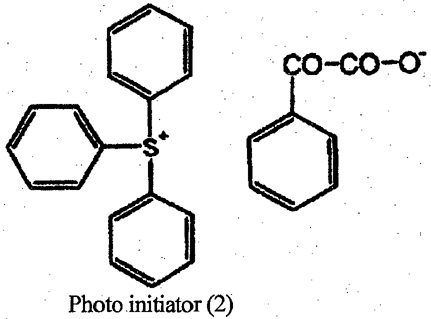

### (Preparation of Microcapsule (1))

An oil phase component was prepared by dissolving 10 g of adduct of trimethylol propane and xylene diisocyanate (TAKENATE D-110N, produced by Mitsui Chemicals Inc., 75% by weight ethyl acetate solution), 6.00 g of ARONIX M-215 (produced by Toagosei Co., Ltd.) and 0.12 g of PIONIN A-41C (produced by Takemoto Oil & Fat Co., Ltd.) in 16.67 g of ethyl acetate. As an aqueous phase component, 37.5 g of an aqueous 4% by weight solution of polyvinyl alcohol (PVA-205, produced by Kuraray Co., Ltd.) was prepared. The oil phase component and the aqueous phase component were mixed and the mixture was emulsified using a homogenizer at 12,000 rpm for 10 minutes. The resulting emulsion was added to 25 g of distilled water and stirred at room temperature for 30 minutes and then at 40°C for 2 hours. The microcapsule liquid thus-obtained was diluted using distilled water so as to have the solid content concentration of 15% by weight to prepare Microcapsule (1). The average particle size of the microcapsule was 0.2 µm.

### [Formation of Protective layer]

Coating solution 6 for protective layer having the composition shown below was coated on the photosensitive layer by a bar and dried in an oven under the condition of 100°C for 60 seconds to form a protective layer having a dry coating amount of 0.1 g/m², thereby preparing Lithographic printing plate precursor (18).

### (Coating solution 6 for protective layer)

| | |
|---|---|
| Dispersion of inorganic stratiform compound (2) shown below | 0.5 g |
| Polyvinyl alcohol (PVA-105, produced by Kuraray Co., Ltd.) | 0.06 g |
| Polyvinyl pyrrolidone (K-30, produced by ISP Japan Co., Ltd.) | 0.006 g |
| Sodium 2-ethylhexylsuccinate | 0.008 g |
| Water | 7.5 g |

### <Preparation of Dispersion of inorganic stratiform compound (2)>

To 368 g of water was added 32 g of synthetic mica (SOMASIF ME-100, produced by CO-OP Chemical Co., Ltd.) and the mixture was dispersed using a homogenizer until an average particle size (according to a laser scattering method) became 2.5 µm to prepare Dispersion of inorganic stratiform compound (2).

Lithographic printing plate precursors (19) and (22) were prepared in the same manner as in Lithographic printing plate precursor (18) except for changing PVA-105 in Coating solution 6 for protective layer to Polymer A shown in Table 6, respectively.

### [Exposure and Printing]

The lithographic printing plate precursor was subjected to exposure by TRENDSETTER 3244VX, produced by Creo Co., equipped with a water-cooled 40 W infrared semiconductor laser under the conditions of output of 9W, a rotational number of an external drum of 210 rpm and resolution of 2,400 dpi. The exposed image contained a fine line chart. The exposed lithographic printing plate precursor was mounted without undergoing development processing on a plate cylinder of a printing machine (SOR-M, produced by Heidelberg). Using dampening water (EU-3 (etching solution, produced by FUJIFILM Corp.))/water/isopropyl alcohol = 1/94/5 (by volume ratio)) and SPACE COLOR FUSION-G (N) Black Ink (produced by DIC Graphics Corp), the dampening water and ink were supplied and printing was conducted on 100 sheets of printing paper (SHIRAOI, high-quality paper, produced by Nippon Paper Industries Co., Ltd.) at a printing speed of 6,000 sheets per hour.

A number of the printing papers required until the on-press development of the unexposed area of the photosensitive layer on the printing machine was completed to reach a state where the ink was not transferred to the printing paper was measured to evaluate the on-press development property.

### [Evaluation]

Ordinarily, in case of a negative lithographic printing plate precursor, when an exposure amount is small, a curing degree of the photosensitive layer becomes low, while when the exposure amount is large, the curing degree of the photosensitive layer becomes high. In the case where the curing degree of the photosensitive layer is too low, printing durability of the lithographic printing plate obtained decreases and reproducibility of small point and fine line is deteriorated. On the contrary, when the curing degree of the photosensitive layer is high, the printing durability increases and the reproducibility of small point and fine line is good.

In the examples, as described below, the lithographic printing plate precursors obtained above were evaluated as to their printing durability and fine line reproducibility under the same exposure amount condition as described above to use as indexes of sensitivity of the lithographic printing plate precursor. Specifically, it can be said that as a number of printing sheet in the printing durability is large or as a width of fine line in the fine line reproducibility is small, the sensitivity of the lithographic printing plate precursor is higher.

The results obtained are shown in Table 6.

### (1) Fine line reproducibility

After the confirmation that printed materials without ink stain in the non-image area were obtained by the printing of 100 sheets as described above, 500 sheets were successively printed. The fine line chart (chart including fine lines of 10,12,14,16,18, 20, 25, 30, 35, 40, 60, 80, 100 and 200 µm in width exposed) on the 600th printed material was observed by a 25-power magnifier and the fine line reproducibility was evaluated from the width (µm) of fine line reproduced by ink without interruption.

### (2) Printing durability

After the printing for the evaluation of fine line reproducibility as described above, the printing was continued. As increase in the number of printed materials, the photosensitive layer was gradually abraded to cause decrease in the ink receptivity, resulting in decrease in ink density on the printing paper. A number of printed materials obtained until the ink density (reflection density) decreased by 0.1 from that at the initiation of printing was determined to evaluate the printing durability.

### (3) On-press development running property

The on-press development and printing (100 sheets) were continuously repeated as to 100 plates of the lithographic printing plate precursors and printing stain (background stain in the non-image area) caused by mixing of residues based on the on-press development into the dampening water and deposition on the impression cylinder were evaluated.

**TABLE 6**

| | Lithographic Printing Plate Precursor | Polymer A | On-press Development Property | Fine Line Reproducibility | Printing Durability | On-press Development Running Property | |
|---|---|---|---|---|---|---|---|
| | | | | | | Background Stain | Deposition on Impression Cylinder |
| Comparative Example 5 | (18) | - | 50 | 12 | 1.5 × 10⁴ | Occurred at 50th Plates | Occurred at 60th Plates |
| Example 14 | (19) | A-1 | 20 | 10 | 2.0 × 10⁴ | Not Occurred | Not Occurred |
| Example 15 | (20) | A-2 | 25 | 10 | 1.9 × 10⁴ | Not Occurred | Not Occurred |
| Example 16 | (21) | A-3 | 30 | 11 | 1.8 × 10⁴ | Not Occurred | Not Occurred |
| Example 17 | (22) | A-4 | 35 | 11 | 1.7 × 10⁴ | Not Occurred | Not Occurred |

As is apparent from the results shown in Table 6, the lithographic printing plate precursor using the coating composition according to the invention in the protective layer is excellent in the printing durability, on-press development property and on-press development running property in comparison with the lithographic printing plate precursor having the conventional protective layer using polyvinyl alcohol.

### Examples 18 and 19 and Comparative Example 6

Coating solution 7 for photosensitive layer shown below was applied to an aluminum substrate subjected to brush graining, anodizing with phosphoric acid and after-treatment with polyacrylic acid (PAA) using a wire wound rod and dried in a Ranar conveyor oven set at 90°C for about 90 seconds. The dry coating amount of the photosensitive layer obtained was 2.0 g/m².

### (Coating solution 7 for photosensitive layer)

| | |
|---|---|
| Radical polymerizable compound (Urethane acrylate shown below) | 3.74 g |
| Radical polymerizable compound (SARTOMER 355) | 0.78 g |
| Photo initiator (2-(4-Methoxyphenyl)-4,6-bis(trichloromethyl)-1,3,5-triazine) | 0.42 g |
| Anilino-N,N-diacetic acid | 0.23 g |
| Infrared absorbing agent (IR-3) | 0.09 g |
| Binder polymer (Graft copolymer 1 shown below) | 3.53 g |
| Surfactant (BYK 307) | 0.02 g |
| n-Propanol | 72.95 g |
| Ion-exchanged water | 18.24 g |

The compounds in the coating solution for photosensitive layer above are shown below.
*Urethane acrylate: Urethane acrylate obtained by a reaction of DESMODUR N100 with hydroxyethyl acrylate and pentaerythritol triacrylate
*Graft copolymer 1: A mixture of 15 g of PEGMA, 192 g of n-propanol and 41 g of deionized water was set in a 500-ml flask and heated to 80°C while purging with continuous nitrogen gas flow and stirring with a mechanical stirrer. A mixture of 66.9 g of styrene and 0.48 g of VAZO-64 was prepared in a separate beaker and 12 g of the mixture was added to the 500-ml flask, followed by continued to stir for 10 minutes. Then, the remainder of the mixture was dropwise added to the 500-ml flask over 30 minutes. The reaction was further continued for 3 hours to obtain Graft copolymer 1.

*DESMODUR N100: Hexamethylene diisocyanate available from Bayer MaterialScience AG
*PEGMA: Poly(ethylene glycol) methyl ether methacrylate as an aqueous 50% by weight solution, Mn -2080, available from Sigma-Aldrich Corp. (St. Louis, Missouri)
*VAZO-64: 2,2'-Azobisisobutyronitrile available from E. I. du Pont de Nemours and Co. (Wilmington, Delaware)
*SARTOMER 355: Polyfunctional acrylate monomer available from Sartomer Co., Ltd.
*Infrared absorbing agent (IR-3): 2-[2-[2-Phenylthio-3-[(1,3-dihydro-1,3,3-trimethyl-2H-indol-2-ylidene)ethylidene]-1-cyclohexen-1-yl]ethenyl]-1,3,3,-trimethyl-3H-indolium chloride
*BYK 307: Modified polysiloxane available from BYK-Chemie GmbH

Coating solution 7 for protective layer having the composition shown below was coated on the photosensitive layer described above by a bar and dried in an oven at 120°C for 60 seconds to form a protective layer having a dry coating amount of 2.0 g/m², thereby preparing Lithographic printing plate precursor (23).

### (Coating solution 7 for protective layer)

| | |
|---|---|
| Polyvinyl alcohol (PVA-205, produced by Kuraray Co., Ltd.) | 5.26 g |
| Polyvinyl imidazole (Mw: 30,000) | 0.93 g |
| Isopropanol | 3.94 g |
| Ion-exchanged water | 89.87 g |

Lithographic printing plate precursors (24) and (25) were prepared in the same manner as in Lithographic printing plate precursor (23) except for changing polyvinyl alcohol in Coating solution 7 for protective layer to Polymer A shown in Table 7, respectively.

### (Evaluation of Lithographic printing plate precursor)

With respect to the lithographic printing plate precursors prepared, on-press development property and printing durability were evaluated in the manner described below. The results obtained are shown in Table 7 below.

### <On-press development property>

The lithographic printing plate precursor was subjected to exposure by TRENDSETTER 3244VX, produced by Creo Co., equipped with a water-cooled 40 W infrared semiconductor laser under the conditions of output of 9W, a rotational number of an external drum of 210 rpm and resolution of 2,400 dpi. The exposed lithographic printing plate precursor was mounted without undergoing development processing on a plate cylinder of a printing machine (SOR-M, produced by Heidelberg). Using dampening water (prepared by diluting CDS803, produced by Tokyo Printing Ink Mfg. Co., Ltd., 50 times with tap water) and SPACE COLOR FUSION-G (N) Black Ink (produced by DIC Graphics Corp.), the dampening water and ink were supplied and printing was conducted on printing paper (SHIRAOI, high-quality paper, produced by Nippon Paper Industries Co., Ltd.) at a printing speed of 6,000 sheets per hour.

A number of the printing papers required until the on-press development of the unexposed area of the photosensitive layer on the printing machine was completed to reach a state where the ink was not transferred to the printing paper was measured to evaluate the on-press development property. The results obtained are shown in Table 7.

### <Printing durability>

After the ink reception, the printing was continued and the photosensitive layer was gradually abraded. With the progress of abrasion of the photosensitive layer, the ink receptivity degraded to initiate decrease of ink density on printing paper. A number of printed materials obtained until the ink density (reflection density) decreased by 0.1 from that at the initiation of printing was determined to evaluate the printing durability. The results obtained are shown in Table

**TABLE 7**

| | Lithographic Printing Plate Precursor | Polymer A | On-press Development Property | Printing Durability |
|---|---|---|---|---|
| Comparative Example 6 | (23) | - | 200 | 0.5 × 10⁴ |
| Example 18 | (24) | A-1 | 120 | 1.0 × 10⁴ |
| Example 19 | (25) | A-6 | 100 | 0.9 × 10⁴ |

As is apparent from the results shown in Table 7, the lithographic printing plate precursor using the coating composition according to the invention in the protective layer is excellent in the printing durability and on-press development property in comparison with the lithographic printing plate precursor having the conventional protective layer using polyvinyl alcohol.

### Examples 20 to 22

### [Preparation of Support]

The support having the anodized film obtained by the anodizing treatment, followed by washing with water and drying as prepared in Examples 8 to 11 was subjected to silicate treatment using an aqueous 2.5% by weight sodium silicate No. 3 solution at 60°C for 10 seconds and subsequently washed with water to prepare a support for use in the experiments described below. The adhesion amount of Si was 10 mg/m². The center line average roughness (Ra) of the support was measured using a stylus having a diameter of 2 µm and found to be 0.51 µm.

### (Formation of Undercoat layer)

Coating solution for undercoat layer shown below was coated on the support prepared by the sodium silicate treatment described above so as to have a dry coating amount of 20 mg/m² to prepare a support having an undercoat layer for use in the experiments described below.

### (Coating solution for undercoat layer)

| | |
|---|---|
| Undercoat compound (1) shown above | 0.18 g |
| Hydroxyethyliminodiacetic acid | 0.10 g |
| Methanol | 55.24 g |
| Water | 6.15 g |

### [Formation of Photosensitive layer]

Coating solution 8 for photosensitive layer having the composition shown below was coated on the undercoat layer described above by a bar and dried in an oven at 100°C for 60 seconds to form a photosensitive layer having a dry coating amount of 1.0 g/m².

Coating solution 8 for photosensitive layer was prepared by mixing Photosensitive solution (2) shown below and Microgel solution (2) shown below just before the coating, followed by stirring.

### <Photosensitive solution (2)>

| | |
|---|---|
| Binder polymer (5) shown below | 0.240 g |
| Infrared absorbing agent (IR-4) having structure shown below | 0.030 g |
| Photo initiator (3) having structure shown below | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.050 g |
| Oil-sensitizing agent (Phosphonium compound (1) having structure shown below) | 0.055 g |
| Oil-sensitizing agent (Benzyl dimethyl octyl ammonium PF₆ salt) | 0.018 g |
| Oil-sensitizing agent (Ammonium group-containing polymer having structure shown below (reduced specific viscosity: 44 cSt/g/ml) | 0.035 g |
| Water-soluble fluorine-based surfactant (1) shown above | 0.008 g |
| 2-Butanone | 1.091 g |
| 1-Methoxy-2-propanol | 8.609 g |

### <Microgel solution (2)>

| | |
|---|---|
| Microgel (2) shown below | 2.640 g |
| Distilled water | 2.425 g |

The structures of Binder polymer (5), Infrared absorbing agent (IR-4), Photo initiator (3), Phosphonium compound (1), Hydrophilic low molecular weight compound (1) and Oil-sensitizing agent (ammonium group-containing polymer) are shown below.
Infrared absorbing agent (IR-4): 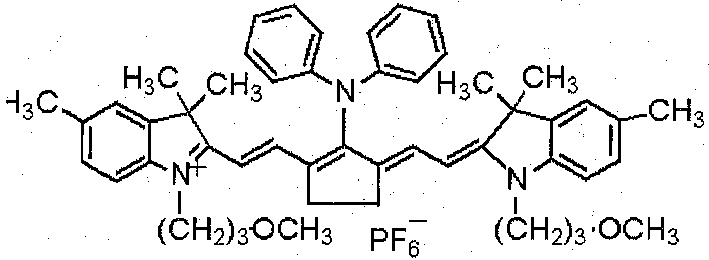 Photo initiator (3): 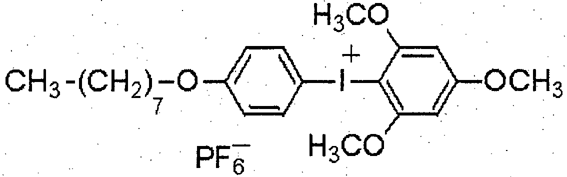 Phosphonium compound (1): 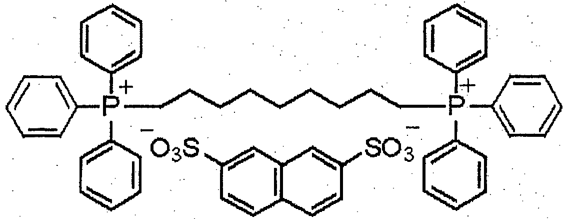 Hydrophilic low molecular weight compound (1): 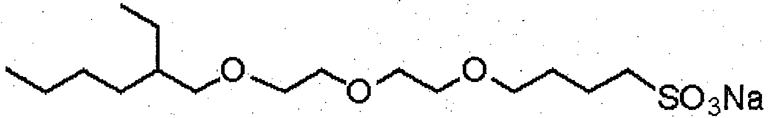 Ammonium group-containing polymer: 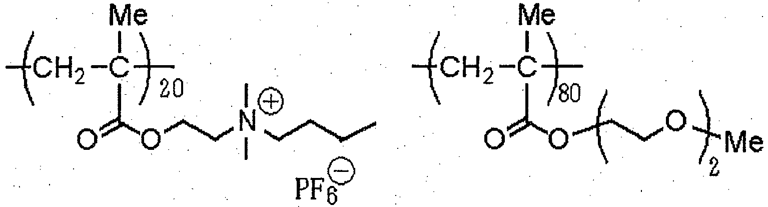 Binder polymer (5):

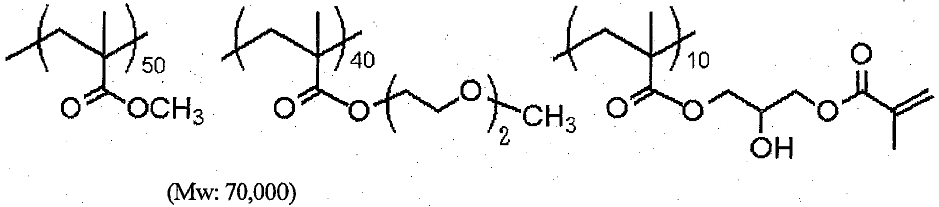

### (Preparation of Microgel (2))

An oil phase component was prepared by dissolving 10 g of adduct of trimethylol propane and xylene diisocyanate (TAKENATE D-110N, produced by Mitsui Chemicals, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g of ethyl acetate. As an aqueous phase component, 40 g of an aqueous 4% by weight solution of PVA-205 was prepared. The oil phase component and the aqueous phase component were mixed and the mixture was emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid content concentration of 15% by weight to prepare Microgel (2). The average particle size of the microgel was measured by a light scattering method and found to be 0.2 µm.

### [Formation of Protective layer]

Coating solution 8 for protective layer having the composition shown below was coated on the photosensitive layer described above by a bar and dried in an oven at 120°C for 60 seconds to form a protective layer having a dry coating amount of 0.15 g/m², thereby preparing Lithographic printing plate precursors (26) to (28), respectively.

### (Coating solution 8 for protective layer)

| | |
|---|---|
| Dispersion of inorganic stratiform compound (3) shown below | 1.5 g |
| Polymer A shown in Table 8 (aqueous 6% by weight solution) | 0.58 g |
| Surfactant (EMALEX 710, produced by Nihon Emulsion Co., Ltd.) (aqueous 1% by weight solution) | 0.86 g |
| Ion-exchanged water | 6.0 g |

### (Preparation of Dispersion of inorganic stratiform compound (3))

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 µm to prepare Dispersion of inorganic stratiform compound (3). The aspect ratio of the inorganic particle thus-dispersed was 100 or more.

### [Evaluation of Lithographic printing plate precursor]

### (1) On-press development property

The lithographic printing plate precursor obtained was exposed by LUXEL PLATESETTER T-6000III equipped with an infrared semiconductor laser produced by FUJIFILM Corp. under the conditions of a rotational number of an external drum of 1,000 rpm, laser output of 70% and resolution of 2,400 dpi. The exposed image contained a solid image and a 50% halftone dot chart of a 20 µm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (by volume ratio)) and SPACE COLOR FUSION-G (N) Black Ink (produced by DIC Graphics Corp.), the dampening water and ink were supplied according to the standard automatic printing start method of LITHRONE 26 to conduct printing on 100 sheets of TOKUBISHI ART paper (76.5 kg) at a printing speed of 10,000 sheets per hour.

A number of the printing papers required until the on-press development of the unexposed area of the photosensitive layer on the printing machine was completed to reach a state where the ink was not transferred to the printing paper in the non-image area was measured to evaluate the on-press development property. The results obtained are shown in Table 8.

### (2) Printing durability

After performing the evaluation for the on-press development property described above, the printing was further continued. As the increase in a number of printing papers, the photosensitive layer was gradually abraded to cause decrease in the ink density on a printed material. A number of printed materials wherein a value obtained by measuring a halftone dot area rate of the 50% halftone dot of FM screen on the printed material using a Gretag densitometer decreased by 5% from the value measured on the 100th printed material of the printing was determined to evaluate the printing durability. The results obtained are shown in Table 8.

**TABLE 8**

| | Lithographic Printing Plate Precursor | Polymer A | On-press Development Property | Printing Durability |
|---|---|---|---|---|
| Example 20 | (26) | A-1 | 8 | 5.6 × 10⁴ |
| Example 21 | (27) | A-7 | 9 | 5.5 × 10⁴ |
| Example 22 | (28) | A-8 | 10 | 5.3 × 10⁴ |

### Examples 23 to 25

### [Preparation of Lithographic printing plate precursor]

Coating solution 9 for photosensitive layer shown below was applied to an aluminum substrate subjected to brush graining, anodizing with phosphoric acid and after-treatment with polyacrylic acid (PAA) using a wire wound rod and dried in a Ranar conveyor oven set at 90°C for about 90 seconds. The dry coating amount of the photosensitive layer obtained was 1.5 g/m².

### (Coating solution 9 for photosensitive layer)

| | |
|---|---|
| Radical polymerizable compound (Urethane acrylate) Binder polymer | 2.48 g |
| Copolymer 1 | 13.53 g |
| Copolymer 2 | 3.97 g |
| KLUCEL M (produced by Hercules Chemical Co., Inc.) | 3.31 g |
| Infrared absorbing agent (IR-5) | 0.13 g |
| Photo initiator (IRGACURE 250, produced by Ciba Specialty Chemicals, Inc.) | 0.42 g |
| Chain transfer agent (Mercapto-3-triazole) | 0.18 g |
| Surfactant (BYK 336, produced by BYK-Chemie GmbH) | 0.60 g |
| n-Propanol | 61.97 g |
| Ion-exchanged water | 13.41 g |

The compounds in the coating solution for photosensitive layer above are shown below.
*Urethane acrylate: 80% by weight 2-butanone solution of urethane acrylate obtained by a reaction of DESMODUR N100 with hydroxyethyl acrylate and pentaerythritol triacrylate
*Copolymer 1: A mixture of 54 g of n-propanol and 16 g of deionized water was set in a 250-ml flask and heated to 70°C while purging with continuous nitrogen gas flow and stirring with a mechanical stirrer. A mixture of 54 g of n-propanol, 16 g of deionized water, 10 g of PEGMA, 4.5 g of styrene, 40.5 g of acrylonitrile and 0.32 g of VAZO-64 was prepared in a separate beaker and then added dropwise to the 250-ml flask over a period of 30 minutes. After 2.5 hours, 0.16 g of VAZO-64 was added to the reaction mixture. The polymerization reaction was further continued for 2 hours. The polymer solution thus-obtained contained 21% by weight (solid content) of Copolymer 1.
*Copolymer 2: In 1-liter four-necked flask was set 384.1 g of 2-butanone and 8.5 g of PEGMA under nitrogen atmosphere, followed by heating to 80°C. A pre-mixture of 38.0 g of allyl methacrylate and 0.3 g of VAZO-64 was added thereto at 80°C over a period of 90 minutes. After the completion of the addition, 0.13 g of VAZO-64 was further added to the reaction mixture. Then, 0.13 g of VAZO-64 was further added twice. The polymer conversion rate based on nonvolatile component percent was more than 98%.
*DESMODUR N100: Hexamethylene diisocyanate available from Bayer MaterialScience AG
*PEGMA: Poly(ethylene glycol) methyl ether methacrylate as an aqueous 50% by weight solution, Mn ~2080, available from Sigma-Aldrich Corp. (St. Louis, Missouri)
*VAZO-64: 2,2'-Azobisisobutyronitrile, available from E. I. du Pont de Nemours and Co. (Wilmington, Delaware)
*Infrared absorbing agent (IR-5): Structure shown below: 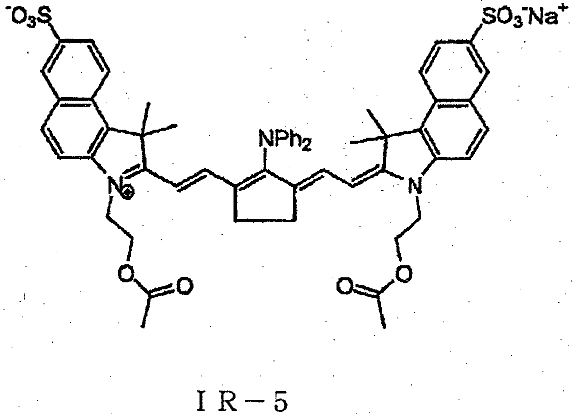
*IRGACURE 250: 75% by weight propylene carbonate solution of (4-methylphenyl)[4-(2-methylpropyl)phenyl]iodonium hexafluorophosphate, available from Ciba Specialty Chemicals, Inc. (Tarrytown, New York)
*BYK 336: 25% by weight xylene/methoxypropyl acetate solution of modified dimethylpolysiloxane copolymer, available from Byk-Chemie USA Inc. (Wallingford, Connecticut)
*KLUCEL M: Aqueous 2% by weight solution of hydroxypropyl cellulose (viscosity: 5,000 mPa·s), available from Hercules Inc., Aqualon Division (Wilmington, Delaware)

Coating solution 9 for protective layer having the composition shown below was coated on the photosensitive layer described above by a bar and dried in an oven at 120°C for 60 seconds to form a protective layer having a dry coating amount of 0.35 g/m², thereby preparing Lithographic printing plate precursors (29) and (31), respectively.

### (Coating solution 9 for protective layer)

| | |
|---|---|
| Dispersion of inorganic stratiform compound (3) shown above | 1.5 g |
| Polymer A shown in Table 9 | Amount shown in Table 9 |
| PVA-105 (produced by Kuraray Co., Ltd.) | |
| Surfactant (EMALEX 710, produced by Nihon Emulsion Co., Ltd.) (aqueous 1% by weight solution) | 0.86 g |
| Ion-exchanged water | 6.0 g |

### [Evaluation of Lithographic printing plate precursor]

With respect to the lithographic printing plate precursors prepared, on-press development property and printing durability were evaluated in the manner described below. The results obtained are shown in Table 9 below.

### <On-press development property>

The lithographic printing plate precursor was subjected to exposure by TRENDSETTER 3244VX, produced by Creo Co., equipped with a water-cooled 40 W infrared semiconductor laser under the conditions of output of 9W, a rotational number of an external drum of 210 rpm and resolution of 2,400 dpi. The exposed lithographic printing plate precursor was mounted without undergoing development processing on a plate cylinder of a printing machine (SOR-M, produced by Heidelberg). Using dampening water (prepared by diluting CDS803, produced by Tokyo Printing Ink Mfg. Co., Ltd., 50 times with tap water) and SPACE COLOR FUSION-G (N) Black Ink (produced by DIC Graphics Corp.), the dampening water and ink were supplied and printing was conducted on printing paper (SHIRAOI, high-quality paper, produced by Nippon Paper Industries Co., Ltd.) at a printing speed of 6,000 sheets per hour.

A number of the printing papers required until the on-press development of the unexposed area of the photosensitive layer on the printing machine was completed to reach a state where the ink was not transferred to the printing paper was measured to evaluate the on-press development property. The results obtained are shown in Table 9.

### <Printing durability>

After the ink reception, the printing was continued and the photosensitive layer was gradually abraded. With the progress of abrasion of the photosensitive layer, the ink receptivity degraded to initiate decrease of ink density on printing paper. A number of printed materials obtained until the ink density (reflection density) decreased by 0.1 from that at the initiation of printing was determined to evaluate the printing durability. The results obtained are shown in Table 9.

**TABLE 9**

| | Lithographic Printing Plate Precursor | Polymer A | | PVA-105 | On-press Development Property | Printing Durability |
|---|---|---|---|---|---|---|
| Example 23 | (29) | A-1 | 0.58 g | None | 19 | 3.5 × 10⁴ |
| Example 24 | (30) | A-3 | 0.58 g | None | 22 | 3.5 × 10⁴ |
| Example 25 | (31) | A-1 | 0.29 g | 0.29 g | 25 | 3.5 × 10⁴ |

### II. Preparation and Evaluation of Oxygen-blocking film using coating composition

### Examples 26 to 29 and Comparative Example 7

An aqueous 10% by weight solution of a polymer shown in Table 10 was prepared, and the aqueous solution was cast on a PET film and allowed to stand under atmosphere at 23°C and 50% RH for 48 hours. Then, the film was placed in a desiccator and dried over diphosphorus penatoxide for 2 weeks, thereby preparing an oxygen-blocking film having a cast film layer (oxygen-blocking layer) having a thickness of 3 µm or 20 µm. Using the film having an oxygen-blocking layer having a thickness of 3 µm, an oxygen transmission rate at 0% RH was measured using an oxygen transmission rate measuring device (OXTRAN 2/20, produced by MOCON, Inc.). The results obtained are shown in Table 10.

**TABLE 10**

| | Polymer A or Comparative Polymer | Oxygen Transmission Rate (cc·3µm/m²·day·atom) |
|---|---|---|
| Example 26 | A-1 | 0.005 |
| Example 27 | A-2 | 0.01 |
| Example 28 | A-3 | 0.015 |
| Example 29 | A-4 | 0.02 |
| Comparative Example 7 | PVA-105 | 0.025 |

Form the results shown in Table 10, it can be seen that the film using the coating composition according to the invention as the oxygen-blocking layer has a high oxygen-blocking property in comparison with a conventional film using polyvinyl alcohol as the oxygen-blocking layer.

### Examples 3 0 to 32 and Comparative Examples 8 to 10

A urethane anchor coat agent was coated in a thickness of 0.2 µm by a gravure coater on an oriented polypropylene (OPP) substrate film having a thickness of 20 µm subjected to a surface corona treatment and then an aqueous 20% by weight solution of a polymer shown in Table 11 was coated at 50°C and dried at 100°C. The thickness of the coating obtained was 1.8 µm. An oxygen transmission rate of the laminate prepared was measured and shown as a value calculated in terms of coating having a thickness of 2.0 µm. The measurement of oxygen transmission rate was conducted using the film allowed to stand under conditions of temperature of 20°C and relative humidity of 85% for 5 days.

**TABLE 11**

| | Polymer A or Comparative Polymer | Oxygen Transmission Rate (cc/m²·day·atom) |
|---|---|---|
| Example 30 | 1 A-11 | 6.5 |
| Example 31 | A-12 | 6.9 |
| Example 32 | A-8 | 6.1 |
| Comparative Example 8 | Ethylene-modified PVA-1 | 9.8 |
| Comparative Example 9 | Ethylene-modified PVA-2 | 7.1 |
| Comparative Example 10 | Ethylene-modified PVA-3 | 68 |

Form the results shown in Table 11, it can be seen that the film using the coating composition according to the invention as the oxygen-blocking layer has a high oxygen-blocking property in comparison with a conventional film using ethylene-modified polyvinyl alcohol as the oxygen-blocking layer.

Ethylene-modified PVA-1 to Ethylene-modified PVA-3 described in Table 11 are shown below.

### *Ethylene-modified PVA-1:

A blend of 95 parts by weight of a 20% by weight methanol solution of Polyvinyl acetate A (viscosity average polymerization degree when fully saponified: 300) having an ethylene modification degree of 15% by mole and 5 parts by weight of a 20% by weight methanol solution of Polyvinyl acetate B (viscosity average polymerization degree when fully saponified: 50) not modified with ethylene was subjected to a saponification reaction at 40°C using sodium hydroxide as a catalyst and the resulting resin was washed with methanol soxhlet for 24 hours. The polyvinyl alcohol obtained had viscosity average polymerization degree of 280, saponification degree of 99.0% by mole, sodium acetate content of 0.2% by weight and dispersity [Pw (weight average polymerization degree)/Pn (number average polymerization degree)] of 2.41.

### *Ethylene-modified PVA-2:

A blend of 70 parts by weight of a 20% by weight methanol solution of polyvinyl acetate (viscosity average polymerization degree when fully saponified: 600) having an ethylene modification degree of 8% by mole as Polyvinyl acetate A and 30 parts by weight of a 20% by weight methanol solution of polyvinyl acetate (viscosity average polymerization degree when fully saponified: 200) having an ethylene modification degree of 10% by mole as Polyvinyl acetate B was subjected to a saponification reaction at 40°C using sodium hydroxide as a catalyst and the resulting resin was washed with methanol soxhlet for 24 hours. The polyvinyl alcohol obtained had viscosity average polymerization degree of 460, saponification degree of 98.0% by mole, sodium acetate content of 0.08% by weight and Pw/Pn of 2.56.

### *Ethylene-modified PVA-3 :

As Polyvinyl acetate A, 100 parts by weight of a 20% by weight methanol solution of polyvinyl acetate (viscosity average polymerization degree when fully saponified: 600) having an ethylene modification degree of 8% by mole was subjected to a saponification reaction at 40°C using sodium hydroxide as a catalyst and the resulting resin was washed with methanol soxhlet for 24 hours. The polyvinyl alcohol obtained had viscosity average polymerization degree of 500, saponification degree of 98.3% by mole, sodium acetate content of 0.32% by weight and Pw/Pn of 2.25.

### Examples 33 to 34 and Comparative Examples 11 to 12

In 11,540 g of water was dissolved 1,220g of PVA resin (ELVANOL 71-30, produced by Du Pont Chemical Co., Ltd., saponification degree of 99.3%). To the solution was added 485 g of glyoxal (aqueous 40% by weight solution). The resulting solution was coated on an oriented polypropylene (OPP) substrate film using a reverse direct gravure coater. The film obtained was dried at 110°C for 3 hours by a dry air oven. Thus, a film (for Comparative Example 11) having PVA as an oxygen-blocking layer was prepared. The thickness of the oxygen-blocking layer was 50µm.

The oxygen-blocking films (for Examples 33 and 34 and Comparative Example 12) were prepared in the same manner as described above except for changing the PVA resin to the resins described in Table 12, respectively.

An oxygen transmission rate (TO₂) of the oxygen-blocking film prepared was measured by OXTRAN device, produced by MOCON, Inc. in a unit of cc/100 cm²/24 hours. The oxygen transmission rate was measured at 0% RH and 75% RH. The results obtained are shown in Table 12.

**TABLE 12**

| | Polymer A or Comparative Polymer | Oxygen Transmission Rate (cc × 10⁻³/100 cm²·day·atom) | |
|---|---|---|---|
| | | 0% RH | 75% RH |
| Comparative Example 11 | ELVANOL 71-30 | 4.96 | 251.1 |
| Comparative Example 12 | ELVANOL 52-22 | 66.65 | 465 |
| Example 33 | A-10 | 4.11 | 190 |
| Example 34 | A-12 | 5.01 | 220 |

| | | | |
|---|---|---|---|
| ELVANOL 52-22 (produced by Du Pont Chemical Co., Ltd., saponification degree of 86%) | | | |

Form the results shown in Table 12, it can be seen that the film using the coating composition according to the invention as the oxygen-blocking layer has a high oxygen-blocking property in comparison with a conventional film using polyvinyl alcohol as the oxygen-blocking layer.

## Claims

1. An oxygen-blocking film having a layer comprising a coating composition containing a polymer having a structural unit represented by the following Formula (1): 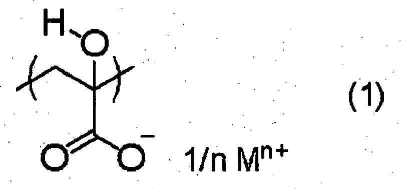 wherein Mⁿ⁺ represents a cation having an n-valent positive charge and n represents an integer of from 1 to 4.

2. An oxygen-blocking film according to Claim 1, wherein the cation in Formula (1) is at least one of a proton, a metal cation, an ammonium cation, a phosphonium cation, an iodonium cation, a sulfonium cation, a diazonium cation and an azinium cation.

3. An oxygen-blocking film according to Claim 2, wherein the cation in Formula (1) is at least one of a proton, a metal cation, an ammonium cation and a phosphonium cation.

4. An oxygen-blocking film according to any preceding claim, wherein the coating composition comprises an inorganic stratiform compound.

5. An oxygen-blocking film according to any preceding claim, wherein the coating composition comprises a crosslinking agent.

6. A lithographic printing plate precursor comprising, in the following order:
a support;
a photosensitive layer comprising a radical polymerizable compound and a photo initiator;and
a protective layer comprising a coating composition containing a polymer having a structural unit represented by the following Formula (1): 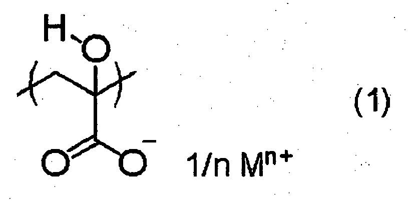 wherein Mⁿ⁺ represents a cation having an n-valent positive charge and n represents an integer of from 1 to 4.

7. A lithographic printing plate precursor according to Claim 6, wherein the cation in Formula (1) is at least one of a proton, a metal cation, an ammonium cation, a phosphonium cation, an iodonium cation, a sulfonium cation, a diazonium cation and an azinium cation.

8. A lithographic printing plate precursor according to Claim 7, wherein the cation in Formula (1) is at least one of a proton, a metal cation, an ammonium cation and a phosphonium cation.

9. A lithographic printing plate precursor according to any of Claims 6 to 8, wherein the coating composition comprises an inorganic stratiform compound.

10. A lithographic printing plate precursor according to of Claims 7 to 9, wherein the coating composition comprises a crosslinking agent.

## Patentansprüche

1. Sauerstoff-blockierender Film, der eine Schicht aufweist, die eine Beschichtungszusammensetzung umfasst, welche ein Polymer enthält, das eine durch die folgende Formel (1) dargestellte Struktureinheit aufweist: 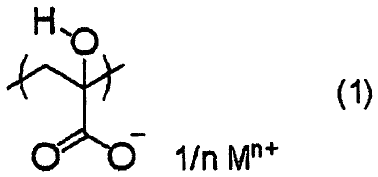 worin Mⁿ⁺ ein Kation mit einer n-wertigen positiven Ladung darstellt und n eine ganze Zahl von 1 bis 4 darstellt.

2. Sauerstoff-blockierender Film gemäß Anspruch 1, worin das Kation in Formel (1) mindestens eines von einem Proton, einem Metallkation, einem Ammoniumkation, einem Phosphoniumkation, einen Jodoniumkation, einem Sulfoniumkation, einem Dazoniumkation und einem Aziniumkation ist.

3. Sauerstoff-blockierender Film gemäß Anspruch 2, worin das Kation in Formel (1) mindestens eines von einem Proton, einem Metallkation, einem Ammoniumkation und einem Phosphoniumkation ist.

4. Sauerstoff-blockierender Film gemäß irgendeinem vorhergehenden Anspruch, worin die Beschichtungszusammensetzung eine anorganische Sichtverbindung umfasst.

5. Sauerstoff-blockierender Film gemäß irgendeinem vorhergehenden Anspruch, worin die Beschichtungszusammensetzung ein Vernetzungsmittel umfasst.

6. Lithografiedruckplattenvorläufer, umfassend in der folgenden Reihenfolge:
einen Träger;
eine fotoempfindliche Schicht, die eine radikalisch polymerisierbare Verbindung und einen Foto-Initiator umfasst; und
eine Schutzschicht, die eine Beschichtungszusammensetzung umfasst, welche ein Polymer enthält, das eine durch die folgende Formel (1) dargestellte Struktureinheit aufweist: 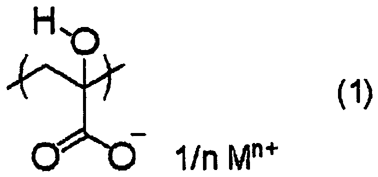 worin Mⁿ⁺ ein Kation mit einer n-wertigen positiven Ladung darstellt und n eine ganze Zahl von 1 bis 4 darstellt.

7. Lithografiedruckplattenvorläufer gemäß Anspruch 6, worin das Kation in Formel (1) mindestens eines von einem Proton, einem Metallkation, einem Ammoniumkation, einem Phosphoniumkation, einen Jodoniumkation, einem Sulfoniumkation, einem Dazoniumkation und einem Aziniumkation ist.

8. Lithografiedruckplattenvorläufer gemäß Anspruch 7, worin das Kation in Formel (1) mindestens eines von einem Proton, einem Metallkation, einem Ammoniumkation und einem Phosphoniumkation ist.

9. Lithografiedruckplattenvorläufer gemäß irgendeinem der Ansprüche 6 bis 8, worin die Beschichtungszusammensetzung eine anorganische Schichtverbindung umfasst.

10. Lithografiedruckplattenvorläufer gemäß irgendeinem der Ansprüche 7 bis 9, worin die Beschichtungszusammensetzung ein Vernetzungsmittel umfasst.

## Revendications

1. Un film barrière anti-oxygène ayant une couche comprenant une composition de revêtement contenant un polymère ayant une unité structurelle représentée par la Formule (1) suivante: 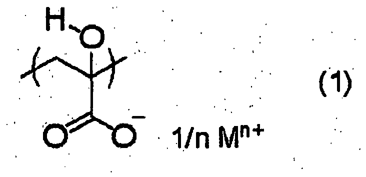 dans laquelle Mⁿ⁺ représente un cation ayant une charge positive n-valente et n représente un entier de 1 à 4.

2. Un film barrière anti-oxygène selon la Revendication 1, dans lequel le cation dans la Formule (1). est au moins l'un de un proton, un cation de métal, un cation ammonium, un cation phosphonium, un cation iodonium, un cation sulfonium, un cation diazonium et un cation azinium.

3. Un film barrière anti-oxygène selon la Revendication 2, dans lequel le cation dans la Formule (1) est au moins l'un de un proton, un cation de métal, un cation ammonium et un cation phosphonium.

4. Un film barrière anti-oxygène selon l'une quelconque des revendications précédentes, dans lequel la composition de revêtement comprend un composé inorganique stratiforme.

5. Un film barrière anti-oxygène selon l'une quelconque des revendications précédentes, dans lequel la composition de revêtement comprend un agent de réticulation.

6. Un précurseur de plaque d'impression lithographique comprenant, dans l'ordre suivant:
un support;
une couche photosensible comprenant un composé polymérisable par voie radicalaire et un photo-initiateur; et
une couche protectrice comprenant une composition de revêtement contenant un polymère ayant une unité structurelle représentée par la Formule (1) suivante: 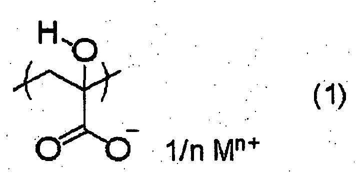 dans laquelle Mⁿ⁺ représente un cation ayant une charge positive n-valente et n représente un entier de 1 à 4.

7. Un précurseur de plaque d'impression lithographique selon la Revendication 6, dans lequel le cation dans la Formule (1) est au moins l'un de un proton, un cation de métal, un cation ammonium, un cation phosphonium, un cation iodonium, un cation sulfonium, un cation diazonium et un cation azinium.

8. Un précurseur de plaque d'impression lithographique selon la Revendication 7 , dans lequel le cation dans la Formule (1) est au moins l'un de un proton, un cation de métal, un cation ammonium et un cation phosphonium.

9. Un précurseur de plaque d'impression lithographique selon l'une quelconque des Revendications 6 à 8, dans lequel la composition de revêtement comprend un composé inorganique stratiforme.

10. Un précurseur de plaque d'impression lithographique selon l'une quelconque des Revendications 7 à 9, dans lequel la composition de revêtement comprend un agent de réticulation.
